(19) Europäisches Patentamt / European Patent Office / Office européen des brevets

(11) **EP 3 440 342 B1**

(12) **FASCICULE DE BREVET EUROPEEN**

(45) Date de publication et mention de la délivrance du brevet:
**08.04.2020 Bulletin 2020/15**

(21) Numéro de dépôt: **17706183.5**

(22) Date de dépôt: **15.02.2017**

(51) Int Cl.:
*F03B 13/16* *(2006.01)*    *F03B 15/00* *(2006.01)*

(86) Numéro de dépôt international:
**PCT/EP2017/053375**

(87) Numéro de publication internationale:
**WO 2017/174244 (12.10.2017 Gazette 2017/41)**

(54) **PROCEDE DE COMMANDE D'UN SYSTEM HOULOMOTEUR AU MOYEN DE LA DÉTERMINATION DE LA FORCE D'EXCITATION EXERCÉE PAR LA HOULE INCIDENTE SUR UN MOYEN MOBILE DUDIT SYSTEM**

KONTROLLVERFAHREN EINES WELLENKRAFTWERKS MITTELS BESTIMMUNG DER VON DER WELLE AUF EINEN BEWEGLICHEN TEIL DES WELLENKRAFTWERKS AUSGEÜBTEN ANREGUNGSKRAFT

CONTROL METHOD OF A WAVE POWER CONVERTER VIA THE DETERMINATION OF THE EXCITATION FORCE APPLIED BY THE WAVE TO A MOBILE ELEMENT OF SAID CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.04.2016 FR 1653109**

(43) Date de publication de la demande:
**13.02.2019 Bulletin 2019/07**

(73) Titulaire: **IFP Energies nouvelles**
**92852 Rueil-Malmaison (FR)**

(72) Inventeurs:
• **NGUYEN, Hoai-Nam**
  **69008 Lyon (FR)**
• **TONA, Paolino**
  **69007 Lyon (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**WO-A1-2009/148531**

• **NIELSEN SÖREN R K ET AL: "Optimal control of nonlinear wave energy point converters", OCEAN ENGINEERING, vol. 72, 24 juillet 2013 (2013-07-24), pages 176-187, XP028711599, ISSN: 0029-8018, DOI: 10.1016/J.OCEANENG.2013.06.029**
• **LOPES M F P ET AL: "Experimental and numerical investigation of non-predictive phase-control strategies for a point-absorbing wave energy converter", OCEAN ENGINEERING, PERGAMON, AMSTERDAM, NL, vol. 36, no. 5, 1 avril 2009 (2009-04-01), pages 386-402, XP026067007, ISSN: 0029-8018, DOI: 10.1016/J.OCEANENG.2009.01.015 [extrait le 2009-02-01]**
• **EDO ABRAHAM ET AL: "Optimal Active Control and Optimization of a Wave Energy Converter", IEEE TRANSACTIONS ON SUSTAINABLE ENERGY, IEEE, USA, vol. 4, no. 2, 1 avril 2013 (2013-04-01), pages 324-332, XP011497607, ISSN: 1949-3029, DOI: 10.1109/TSTE.2012.2224392**
• **FRANCESCO FUSCO ET AL: "A Simple and Effective Real-Time Controller for Wave Energy Converters", IEEE TRANSACTIONS ON SUSTAINABLE ENERGY, IEEE, USA, vol. 4, no. 1, 1 janvier 2013 (2013-01-01) , pages 21-30, XP011479415, ISSN: 1949-3029, DOI: 10.1109/TSTE.2012.2196717**

- **EDO ABRAHAM ET AL: "Optimal active control of a wave energy converter", DECISION AND CONTROL (CDC), 2012 IEEE 51ST ANNUAL CONFERENCE ON, IEEE, 10 décembre 2012 (2012-12-10), pages 2415-2420, XP032324695, DOI: 10.1109/CDC.2012.6426993 ISBN: 978-1-4673-2065-8**

**Description**

L'invention concerne le domaine des dispositifs pour convertir l'énergie des vagues en énergie électrique. En particulier, l'invention concerne le domaine de la détermination de la force d'excitation par la houle incidente sur un moyen mobile, notamment pour la commande d'un système houlomoteur.

Les ressources énergétiques renouvelables connaissent un fort intérêt depuis quelques années. Ces ressources sont propres, gratuites et inépuisables, autant d'atouts majeurs dans un monde rattrapé par la diminution inexorable des ressources fossiles disponibles et prenant conscience de la nécessité de préserver la planète. Parmi ces ressources, l'énergie houlomotrice, source relativement méconnue au milieu de celles largement médiatisées comme l'éolien ou le solaire, contribue à la diversification indispensable de l'exploitation des énergies renouvelables. Les dispositifs, couramment appelés appareils "houlomoteurs", sont particulièrement intéressants, car ils permettent de produire de l'électricité à partir de cette source d'énergie renouvelable (l'énergie potentielle et cinétique des vagues) sans émission de gaz à effet de serre. Ils sont particulièrement bien adaptés pour fournir de l'électricité à des sites insulaires isolés.

Par exemple, les demandes de brevet FR 2876751, et WO 2009/081042 décrivent des appareils pour capter l'énergie produite par le flot marin. Ces dispositifs sont composés d'un support flottant sur lequel est disposé un pendule monté mobile par rapport au support flottant. Le mouvement relatif du pendule par rapport au support flottant est utilisé pour produire de l'énergie électrique au moyen d'une machine de conversion de l'énergie (par exemple une machine électrique). La machine de conversion fonctionne en tant que générateur et en tant que moteur. En effet, pour fournir un couple ou une force qui entraîne le mobile, on fournit une puissance à la machine de conversion afin de mettre le mobile en résonance avec les vagues (mode moteur). Par contre, pour produire un couple ou force qui résiste au mouvement du mobile, on récupère une puissance via la machine de conversion (mode générateur).

Dans l'intention d'améliorer le rendement et donc la rentabilité des dispositifs pour convertir l'énergie des vagues en énergie électrique (systèmes houlomoteurs), il est intéressant d'estimer la force d'excitation exercée par la houle incidente sur le système houlomoteur.

La force appliquée par la houle aux dispositifs pour convertir l'énergie des vagues en énergie électrique ou d'autres formes d'énergie exploitable, couramment appelés houlomoteurs, n'est pas directement mesurable en conditions de fonctionnement normales dans un contexte industriel. Pour les convertisseurs ponctuels oscillants, il est possible de réaliser des essais spécifiques, consistant à bloquer la partie flottante de la machine et à mesurer l'effort nécessaire pour contrer l'action de la vague (c'est-à-dire pour maintenir le flotteur immobile) à travers un ou plusieurs capteurs (de force ou de couple) placés sur la machine de conversion, appelée aussi système de prise de puissance (PTO), par exemple un générateur électrique assorti d'un dispositif permettant de transmettre le mouvement oscillatoire du moyen mobile. Selon la terminologie courante, on appelle la quantité ainsi mesurée, force d'excitation de la houle (ou vague) incidente, en la distinguant notamment de la force (et de la houle) générée par le mouvement même du flotteur (force de radiation). Durant le fonctionnement normal du flotteur, en revanche, les mêmes capteurs d'effort mesureront seulement la force appliquée par le PTO, et non pas la force d'excitation de la houle incidente. Il serait possible, en principe, de calculer l'ensemble des forces appliquées par la houle en intégrant des mesures de pression provenant de capteurs distribués sur toute la surface, mais il s'agit là d'une solution coûteuse et peu robuste qui peut difficilement être envisagée dans un contexte industriel.

Il y a peu de travaux scientifiques dans le domaine de l'estimation en temps-réel de la force (ou du couple) d'excitation de la vague. Par exemple, on peut citer le document Peter Kracht, Sebastian Perez-Becker, Jean-Baptiste Richard, and Boris Fischer. "Performance Improvement of a Point Absorber Wave Energy Converter by Application of an Observer-Based Control: Results from Wave Tank Testing". Dans IEEE Transactions on Industry Applications, juillet 2015, qui décrit un algorithme d'estimation de la force de la houle, celui-ci est basé sur banc d'oscillateurs harmoniques indépendants et un observateur de Luenberger. Les résultats obtenus avec cette méthode montrent que les estimations sont retardées (déphasées) de manière significative par rapport à la vraie force d'excitation, ce qui est gênant notamment pour une utilisation dans le cadre du contrôle du système houlomoteur. Plus généralement, cette approche considère une plage de fréquence de fréquence fixe (choisie a priori) pour le spectre de la houle. Pour que la méthode puisse marcher dans des conditions réalistes, où le spectre est variant dans le temps, il faut prendre en compte un nombre très élevé de fréquences, ce qui rend l'approche très lourde en termes de calculs. Dans le document Bradley A Ling. "Real-Time Estimation and Prediction of Wave Excitation Forces for Wave Energy Control Applications",publié dans ASME 2015 34th

International Conférence on Ocean, Offshore and Arctic Engineering, une approche basée sur un filtre de Kalman étendu est proposée pour reconstruire le spectre en considérant la force d'excitation de la vague comme une (seule) sinusoïde dont les paramètres (amplitude, fréquence et phase) varient dans le temps. Toutefois, la méthode ne peut être efficace que pour des vagues dans une bande de fréquences très étroite.

En outre, la demande de brevet FR2973448 (US9261070) décrit une méthode de commande pour convertisseurs ponctuels oscillants dont une des étapes est l'estimation (du spectre) de la force de la houle sur le flotteur (ou du couple sur la partie mobile du convertisseur), à partir d'un ensemble de sinusoïdes et d'un observateur de Luenberger.

La méthode s'apparente à celle publiée dans les documents précédemment cités, et présente a priori les mêmes désavantages.

De plus, le document : NIELSEN SÖREN R K ET AL : « Optimal control of non linear wave energy point converter », OCEAN ENGINEERING, vol. 72, 24 juillet 2013, pages 176-187, décrit une méthode de contrôle d'un système houlomoteur de type non linéaire.

L'invention propose d'améliorer le fonctionnement d'un appareil houlomoteur en déterminant en temps réel les efforts exercés par la houle incidente sur le moyen mobile, afin d'adopter en conséquence les meilleurs réglages des stratégies de récupération de l'énergie électrique. Le procédé selon l'invention est basé sur la construction d'un modèle de la force de radiation exercée sur le moyen mobile, et d'un modèle de la dynamique du système houlomoteur. L'invention utilise seulement des mesures de la cinématique du flotteur (position, vitesse et éventuellement accélération) et de la force appliquée par la machine de conversion, mesures normalement disponibles sur un système houlomoteur, car utilisées pour son contrôle et pour sa supervision. Ainsi, grâce aux modèles utilisés, il est possible d'estimer la force exercée par la houle incidente pour toute plage de fréquences des vagues, tout en gardant un temps de calcul adapté à une détermination et un contrôle en temps réel.

**Le procédé selon l'invention**

L'invention concerne un procédé de commande d'un système houlomoteur au moyen de la détermination de la force d'excitation exercée par la houle incidente sur un moyen mobile d'un système houlomoteur, ledit système houlomoteur convertissant l'énergie de la houle en énergie au moyen dudit moyen mobile coopérant avec une machine de conversion, ledit moyen mobile effectuant un mouvement par rapport à ladite machine de conversion sous l'action de la houle. Pour ce procédé, on réalise les étapes suivantes :

a) on mesure la position et la vitesse dudit moyen mobile ;
b) on mesure la force $F_u$ exercée par ladite machine de conversion sur ledit moyen mobile ;
c) on construit un modèle de la force $F_{rad}$ de radiation exercée sur ledit moyen mobile, ledit modèle de la force $F_{rad}$ de radiation reliant ladite force de radiation à la vitesse dudit moyen mobile ;
d) on construit un modèle de dynamique dudit système houlomoteur qui relie ladite force d'excitation $F_{ex}$ exercée par la houle incidente sur ledit moyen mobile, à ladite position dudit moyen mobile, à ladite vitesse du moyen mobile, à ladite force $F_u$ exercée par ladite machine de conversion sur ledit moyen mobile et à ladite force de radiation $F_{rad}$ exercée sur ledit moyen mobile ; et
e) on détermine ladite force d'excitation $F_{ex}$ exercée par la houle incidente sur ledit moyen mobile au moyen dudit modèle de dynamique, dudit modèle de la force de radiation, desdites position et vitesse mesurées et de ladite force $F_u$ mesurée exercée par ladite machine de conversion sur ledit moyen mobile; et
f) on commande ledit système houlomoteur en fonction de ladite force d'excitation Fex exercée par la houle incidente sur ledit moyen mobile, déterminée.

Selon un mode de réalisation, on construit ledit modèle de dynamique dudit système houlomoteur au moyen d'une équation du type : $M\ddot{z}(t) = F_{ex}(t) + F_{hd}(t) + F_{rad}(t) - F_u(t)$ avec M la masse du moyen mobile, $\ddot{z}$ l'accélération dudit moyen mobile, $F_{hd}$ la force de rappel hydrostatique exercée sur ledit moyen mobile.

Selon une alternative, on détermine ladite force $F_{hd}$ de rappel hydrostatique au moyen d'une formule du type : $F_{hd}(t) = -Kz(t)$ avec z la position dudit moyen mobile et K le coefficient de raideur hydrostatique.

Alternativement, on détermine ladite force $F_{hd}$ de rappel hydrostatique par une fonction affine par morceau du type : $F_{hd} = -F_i z(t) - G_i$ pour au moins deux intervalles $\Omega_i$ de variation de ladite position z, avec $F_i$ et $G_i$ des coefficients constants de ladite fonction affine pour chaque intervalle $\Omega_i$.

Conformément à une mise en œuvre, on construit ledit modèle de la force $F_{rad}$ de radiation par une équation du type: $F_{rad}(t) = -M_\infty \ddot{z}(t) - F_r(t)$ avec $F_r(t) = \int_0^t h(t - \tau)\dot{z}(\tau)d\tau$ l'amortissement de radiation, $\ddot{z}$ l'accélération dudit moyen mobile, $M_\infty$ la masse ajoutée à la fréquence infiniment élevée, z la vitesse dudit moyen mobile, h la réponse impulsionnelle qui relie la vitesse du moyen mobile à l'amortissement de radiation.

Avantageusement, on mesure l'accélération dudit moyen mobile.

Selon un premier mode de réalisation, on détermine l'amortissement de radiation $F_r$ au moyen d'une réponse temporelle approximée issue d'une réalisation d'état, du type : $F_r(t) = C_r \int_0^t e^{(t-\tau)A_r} B_r \dot{z}(\tau)\, d\tau + D_r \dot{z}(t)$ avec $A_r, B_r, C_r, D_r$ des matrices de la réalisation d'état.

De préférence, on détermine ladite force d'excitation $F_{ex}$ exercée par la houle incidente sur ledit moyen mobile (2) au moyen d'une équation du type: $\hat{F}_{ex}(k) = (M + M_\infty)\ddot{z}(k) +$ $\sum_{l=0}^{k-1} C_{rd} A_{rd}^{k-1-l} B_{rd} \dot{z}(l) + D_{rd}\dot{z}(k) + F_i z(k) + G_i + F_u(k)$ avec k le pas de temps dans le domaine discret, $A_{rd}, B_{rd}, C_{rd}, D_{rd}$ les matrices de la réalisation d'état dans le domaine discret.

Selon un deuxième mode de réalisation, on détermine ladite force d'excitation $F_{ex}$ exercée par la houle incidente sur ledit moyen mobile au moyen d'un observateur d'état basé sur un filtre de Kalman linéaire construit à partir d'un modèle de marche aléatoire de ladite force d'excitation $F_{ex}$ exercée par la houle incidente sur ledit moyen mobile.

De manière avantageuse, on détermine ladite force d'excitation $F_{ex}$ exercée par la houle incidente sur ledit moyen mobile en mettant en œuvre les étapes suivantes :

i) on initialise k=0, le vecteur d'état $\hat{x}_a(0|0) = \bar{x}_a(0)$ et l'état de la matrice de covariance, $P(0|0) = P_0$,;

ii) à chaque instant k, on acquiert lesdites mesures de position et de vitesse dudit moyen mobile $y(k) = [z(k)\ \dot{z}(k)]$ et la mesure de ladite force exercée par ladite machine de conversion sur ledit moyen mobile $u(k) = F_u(k)$ ; et

iii) à chaque instant k, on détermine la force d'excitation exercée par la houle incidente sur ledit moyen mobile (2) $\hat{w}(k)$ au moyen des équations suivantes :

$$\hat{w}(k) = \begin{bmatrix} 0 & 1 \end{bmatrix} \hat{x}_a(k|k)$$

avec :

$$\begin{cases} \hat{x}_a(k|k-1) = A_a \hat{x}_a(k-1|k-1) + B_a F_u(k-1) \\ P(k|k-1) = A_a P(k-1|k-1)A_a^T + Q \end{cases},$$

$$K(k) = P(k|k-1)C_a^T(C_a P(k|k-1)C_a^T + R)^{-1}$$

$$\hat{x}_a(k|k) = \hat{x}_a(k|k-1) + K(k)(y(k) - C_a \hat{x}_a(k|k-1) - D_a F_u(k))$$

$$P(k|k) = (I - K(k)C_a(k))P(k|k-1)$$

avec K(k) le gain de l'observateur, $x_a(k)$ le vecteur d'état inconnu $x_a(k) = \begin{bmatrix} x(k) \\ w(k) \end{bmatrix}$, $A_a, B_a, C_a, D_a$ des matrices de la réalisation d'état, P la matrice de covariance du vecteur d'état, Q et R des matrices de calibration.

Selon un troisième mode de réalisation, on détermine ladite force d'excitation $F_{ex}$ exercée par la houle incidente sur ledit moyen mobile au moyen d'un estimateur d'état à entrée inconnue basé sur une approche d'horizon glissant.

Conformément à une caractéristique, on détermine ladite force d'excitation $F_{ex}$ exercée par la houle incidente sur ledit moyen mobile en mettant en œuvre les étapes suivantes à chaque instant k :

i) on acquiert lesdites mesures de position et de vitesse dudit moyen mobile $y(k) = [z(k)\ \dot{z}(k)]$ et la mesure de ladite force exercée par ladite machine de conversion sur ledit moyen mobile $u(k) = F_u(k)$ ; et

ii) on détermine la force d'excitation exercée par la houle incidente sur ledit moyen mobile $\hat{w}(k|k)$ au moyen des équations suivantes : $\hat{w}(k|k) = \xi(N)$ avec $\xi(N)$ obtenu par résolution d'un problème de programmation quadratique suivant :

$$\begin{cases} \min_\xi \left\{ \xi^T(\mathbf{P} + \Psi_s^T \mathbf{R}\Psi_s)\xi - 2[\hat{w}_0^T\ \ \hat{x}_0^T\ \ V^T]\begin{bmatrix} \mathbf{S} \\ \mathbf{R}\Psi_s \end{bmatrix}\xi \right\} \\ \text{tel que } H_\xi \xi \leq g_\xi + H_d U_d \end{cases}$$

avec P, R et S des matrices formées à partir de matrices de pondération de la fonction coût, $\xi$ la matrice qui représente l'ensemble des valeurs des variables inconnues sur la fenêtre d'estimation de dimension $N$, $\Psi_s$ la matrice, calculée à partir de la représentation d'état, qui correspond à l'effet de ces variables sur les valeurs des sorties sur cette même fenêtre, $H_\xi$ et $H_d$ des matrices et $g_\xi$ un vecteur obtenus à partir de contraintes imposées sur l'état et l'entrée inconnue, $\hat{x}_0 = \hat{x}(k - N|k - 1)$ et $\hat{w}_0 =$

$$U_d = \begin{bmatrix} u_d(k - N) \\ u_d(k - N + 1) \\ \vdots \\ u_d(k) \end{bmatrix}_{u_d},$$

$\hat{w}(k - N|k - 1)$ avec x le vecteur d'état et w l'entrée inconnue de l'estimateur d'état, étant l'entrée connue de l'estimateur d'état avec $u_d(t)=F_{hd}(t) - F_u(t)$.

Selon une mise en œuvre, on commande ledit système houlomoteur en fonction de ladite force d'excitation $F_{ex}$ exercée par la houle incidente sur ledit moyen mobile, déterminée.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre un système houlomoteur selon un mode de réalisation de l'invention.
La figure 2 illustre une approximation de la force de rappel hydrostatique en fonction de la position selon un exemple.
La figure 3 illustre l'amplitude de la houle pour la mise en œuvre de l'exemple illustratif.
Les figures 4a à 4c illustrent la force d'excitation exercée par la houle incidente sur le moyen mobile en fonction du temps, pour une houle de type W1 conformément à la figure 3, obtenue par mesure et respectivement par un des modes de réalisation du procédé selon l'invention.
Les figures 5a à 5c illustrent la force d'excitation exercée par la houle incidente sur le moyen mobile en fonction du temps, pour une houle de type W3 conformément à la figure 3, obtenue par mesure respectivement par une des modes de réalisation du procédé selon l'invention.

## Description détaillée de l'invention

La présente invention concerne la détermination de la force d'excitation exercé par la houle incidente sur un moyen mobile d'un système houlomoteur, appelée aussi force d'excitation de la houle ou de la vague. Un système houlomoteur est un système qui convertit l'énergie de la houle en énergie récupérable, en particulier en énergie électrique. Un système houlomoteur comporte généralement un moyen mobile, également appelé pendule ou flotteur, qui a un mouvement oscillatoire sous l'action de la houle. Le moyen mobile coopère avec une machine de conversion, appelée aussi système de prise de puissance (PTO de l'anglais « power take off »), qui comporte dans la plupart des cas un générateur électrique couplé à un dispositif permettant d'adapter la transmission du mouvement oscillatoire, pour convertir le mouvement du moyen mobile en énergie récupérable. Dans certains cas, la machine de conversion peut agir en tant que moteur en générant un effort sur le moyen mobile. En effet, pour récupèrer une puissance via la machine de conversion, on produit un couple ou force qui résiste au mouvement du mobile (mode générateur). Par contre, si la machine de conversion le permet, on peut fournir une puissance à la machine de conversion pour fournir un couple ou une force qui entraîne le mobile afin de l'aider à se mettre en résonance avec les vagues (mode moteur). Le procédé selon l'invention concerne la commande d'un système houlomoteur en fonction de la force d'excitation déterminée.
Le procédé selon l'invention est adapté à tout type de système houlomoteur avec au moins un moyen mobile, par exemple ceux décrits dans la demande de brevet FR2973448 (US9261070). Le procédé de commande selon l'invention peut être également appliqué un système houlomoteur appartenant à la catégorie de systèmes houlomoteurs avec colonnes d'eau oscillantes (OWC de l'anglais Oscillating Water Column).

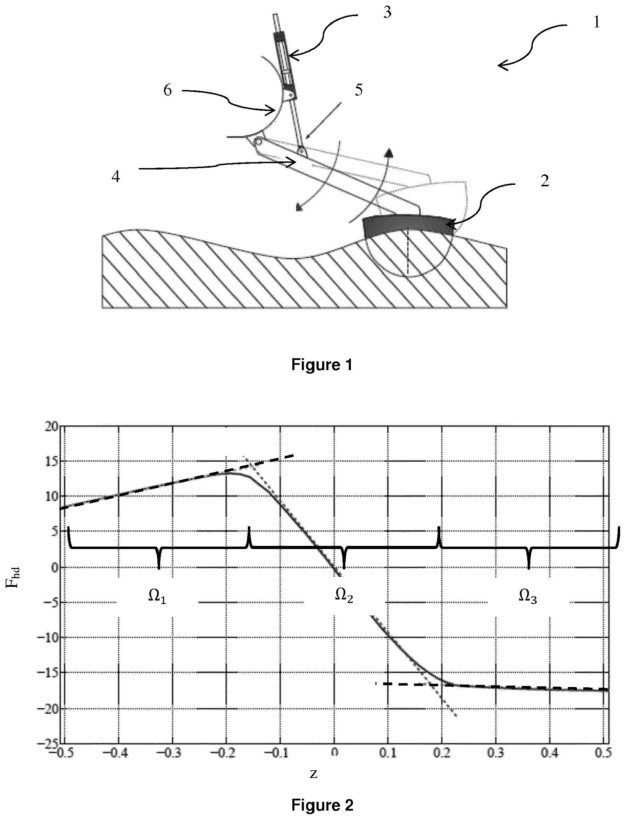

La figure 1 illustre, de manière schématique, un exemple non limitatif de système houlomoteur 1. Le système houlomoteur 1 comporte un moyen mobile 2, qui flotte (la houle est représentée de manière schématique par la surface hachurée). Le moyen mobile 2 coopère, au moyen d'un bras de levier 4, avec une machine de conversion basée sur un générateur électrique 3, qui est, dans ce cas, un générateur linéaire. Le bras de levier 4 et le générateur électrique sont articulés par rapport à une installation 6. Les mouvements du bras de levier sont représentés schématiquement par des flèches.
Dans la suite de la description et pour les revendications, les termes vagues, flots marins, et houle sont considérés comme équivalents.

De plus, dans la description et pour les revendications, le terme force désigne un effort ou un couple. De la même manière, les termes position, vitesse et accélérations désignent à la fois des valeurs « linéaires » ou « angulaires », les valeurs « linéaires » pouvant être associées aux efforts, et les valeurs « angulaires » pouvant être associées aux couples.

En outre, pour une meilleure compréhension, les différents modèles sont représentés en une seule dimension, toutefois, le procédé selon l'invention est adapté à des modèles à plusieurs dimensions, pour des systèmes ayant plusieurs degrés de liberté dans leur mouvement.

Le procédé selon l'invention comporte les étapes suivantes :

1) mesure de la position et de la vitesse du moyen mobile
2) mesure de la force exercée par la machine de conversion (ou PTO)
3) construction du modèle de force de radiation
4) construction du modèle de dynamique
5) détermination de la force d'excitation de la houle incidente
6) commande du système houlomoteur

1) Mesure de la position et de la vitesse du moyen mobile

Lors de cette étape, la position et la vitesse du moyen mobile sont mesurées. La position correspond au mouvement (par exemple distance ou angle) par rapport à la position d'équilibre du moyen mobile. Ces mesures peuvent être réalisées au moyen de capteurs, généralement implémentés sur un système houlomoteur pour son contrôle et/ou sa supervision.

Selon une mise en œuvre de l'invention, lors de cette étape, on peut également mesurer ou estimer l'accélération du moyen mobile, car cette mesure ou estimation peut être utilisée dans les modèles mis en œuvre par le procédé selon l'invention. Par exemple, l'accélération peut être mesurée au moyen d'un accéléromètre placé sur le moyen mobile.

2) Mesure de la force exercée par la machine de conversion (PTO)

Lors de cette étape, on mesure la force (l'effort ou le cas échéant le couple) exercée par la machine de conversion PTO sur le moyen mobile. Cette mesure peut être réalisée au moyen d'un capteur, qui peut être un capteur d'effort ou un capteur de couple. Ce type de capteur est souvent installé, ou peut être facilement installé dans les systèmes houlomoteurs, pour leur contrôle et/ou leur supervision. Alternativement, la mesure peut être remplacée par une estimation réalisée à partir de la consigne de force (ou de couple) envoyée au PTO.

Pour l'exemple de système houlomoteur illustré sur la figure 1, un capteur de couple 5 peut être disposé entre le bras de levier 4 et le générateur électrique 3.

3) Construction d'un modèle de force de radiation

Lors de cette étape, on construit un modèle de la force de radiation exercée sur le moyen mobile. Selon la théorie linéaire des vagues (comme décrit par exemple dans le document Faines J, Kurniawan A. "Fundamental formulae for wave-energy conversion". R. Soc. open sci. 2: 140305, 2005, http://dx.doi.org/10.1098/rsos.140305), la force de radiation résulte de l'oscillation d'un corps immergé (donc dépend du mouvement du moyen mobile), tandis que la force d'excitation, résultant de la présence même d'un corps dans l'eau, ne dépend pas du mouvement du corps immergé, mais de la vague incidente. En l'absence de houle incidente, la force de radiation amortit l'oscillation résiduelle du corps immergé jusqu'à l'arrêter. Il est important de noter que, bien que la théorie linéaire permette de relier la force d'excitation à l'élévation de la vague incidente à travers un modèle linéaire (dans le domaine fréquentiel ou temporel), en pratique on ne peut pas s'en servir pour calculer la force d'excitation en ligne, même si c'était possible de mesurer l'élévation de la vague au centre de gravité du flotteur comme le requiert la théorie. En effet, la relation linéaire entre élévation de la vague et force d'excitation est non-causale, ce qui veut dire qu'on ne peut pas calculer la force d'excitation à un instant donné sans connaître l'élévation de la vague dans les instants futurs (le calcul peut en revanche être fait hors ligne, une fois la vague passée). Dans un contexte de contrôle en temps-réel, la force d'excitation ne peut pas donc être considérée que comme une force exogène totalement inconnue agissant sur le flotteur. En revanche, toujours selon la théorie linéaire des vagues, la force de radiation est reliée au mouvement du flotteur, et plus précisément à son accélération et à sa vitesse par un modèle linéaire (dans le domaine fréquentiel ou temporel) causal. Elle peut donc être calculée en ligne en utilisant les mesures d'accélération et vitesse courantes (et passées pour la vitesse).

Selon une mise en œuvre de l'invention, on construit ledit modèle de la force $F_{rad}$ de radiation par une équation du type :

$$F_{rad}(t) = -M_\infty \ddot{z}(t) - F_r(t)$$

avec $F_r(t) = \int_0^t h(t-\tau)\dot{z}(\tau)d\tau$ la composante de ladite force $F_{rad}$ de radiation qui dépend de la vitesse (courante et passée) du moyen mobile, que l'on peut appeler amortissement de radiation ,

$\ddot{z}$ l'accélération du moyen mobile,

$M_\infty$ la masse ajoutée à la fréquence infiniment élevée, que l'on peut obtenir par des codes de codes de calcul BEM (« Boundary Element Method » signifiant méthode des éléments de frontières), tels que WAMIT ® (WAMIT, USA), ou Nemoh ® (Ecole Centrale de Nantes, France), à partir de la géométrie du moyen mobile,

$\dot{z}$ la vitesse du moyen mobile,

$h$ la réponse impulsionnelle qui relie la vitesse du moyen mobile à l'amortissement de radiation, dont les coefficients s'obtiennent à partir des paramètres hydrodynamiques du moyen mobile calculés par les mêmes codes de calcul BEM.

La construction de ce modèle permet une détermination à tout instant de la force de radiation, avec un temps de calcul limité. Ainsi, la détermination de la force exercée par la houle peut être déterminée à tout instant avec un temps de calcul court.

_4) Construction du modèle de dynamique du système houlomoteur_

Lors de cette étape, on construit un modèle de dynamique du système houlomoteur. On appelle modèle de dynamique un modèle qui relie la force d'excitation exercée par la houle incidente sur le moyen mobile, la force de radiation exercée sur le moyen mobile, la force de rappel hydrostatique exercée sur le moyen mobile, la force exercée par la machine de conversion sur le moyen mobile, à la position et la vitesse du moyen mobile. Ce type de modèle permet d'obtenir des résultats représentatifs du comportement du système houlomoteur, si les mouvements ne sont pas trop grands.

Avantageusement, le modèle de dynamique est obtenu par application du principe fondamental de la dynamique (deuxième loi de Newton) au niveau du moyen mobile.

Selon une mise en œuvre de l'invention, pour lequel on considère les efforts, on peut construire le modèle de dynamique du système houlomoteur par une équation du type :

$$M\ddot{z}(t) = F_{ex}(t) + F_{hd}(t) + F_{rad}(t) - F_u(t)$$

avec M la masse du moyen mobile,

$\ddot{z}$ l'accélération du moyen mobile,

$F_{ex}$ la force d'excitation exercée par la houle incidente sur le moyen mobile,

$F_{rad}$ la force de radiation exercé sur le moyen mobile,

$F_{hd}$ la force de rappel hydrostatique exercée sur le moyen mobile, et

$F_u$ la force exercée par la machine de conversion sur le moyen mobile.

Ce modèle traduit un mouvement de translation vertical (typique des flotteurs ayant un mouvement de pillonement). Ce modèle est dérivé de la théorie linéaire des vagues.

Conformément à une première variante de réalisation, la force de rappel hydrostatique exercée sur le moyen mobile peut être approximée par une fonction linéaire de la position $z$ définie par rapport à la position d'équilibre. Dans ce cas, la force de rappel hydrostatique peut s'écrire par une fonction du type : $F_{hd}(t) = -Kz(t)$ avec $z$ la position dudit moyen mobile définie par rapport à sa position d'équilibre et $K$ le coefficient de raideur hydrostatique. Ainsi, la force de rappel hydrostatique peut être calculée à partir d'un modèle simple si l'on dispose de la mesure de la position $z$. Cette fonction est particulièrement adaptée pour les petits déplacements $z$.

Conformément à une deuxième variante de réalisation, la force de rappel hydrostatique exercée sur le moyen mobile peut être approximée par une fonction affine par morceaux de la position $z$. La fonction peut être linéaire sur au moins deux, de préférence trois intervalles de la position $z$. Dans ce cas, la force de rappel hydrostatique peut s'écrire par une fonction du type : $F_{hd} = -F_i z(t) - G_i$ pour au moins deux intervalles $\Omega_i$ de variation de la position z, avec $F_i$ et $G_i$ des coefficients constants de la fonction affine pour chaque intervalle $\Omega_i$. Cette fonction est particulièrement adaptée pour les mouvements z plus larges. La figure 2 illustre cette approximation. La figure 2 illustre en trait continu, de manière schématique et non limitative, les variations de la force de rappel hydrostatique $F_{hd}$ en fonction de la position z. Sur cette figure, sont représentés en traits pointillés les fonctions linéaires de chaque morceau $\Omega_1$, $\Omega_2$ et $\Omega_3$. On remarque

que cette fonction affine par morceaux permet une meilleure approximation de l'effort de rappel hydrostatique sur l'ensemble de la plage de variation de la position z.

Selon une mise en œuvre de l'invention, pour lequel on considère les couples, on peut construire le modèle de dynamique du système houlomoteur par une équation du type :

$$J\ddot{\theta}(t) = M_{ex}(t) + M_{hyd}(t) + M_{rad}(t) - M_u(t)$$

avec J l'inertie du moyen mobile,
$\ddot{\theta}$ l'accélération angulaire du moyen mobile,
$M_{ex}$ le couple d'excitation exercé par la houle incidente sur le moyen mobile,
$M_{rad}$ le couple de radiation exercé sur le moyen mobile,
$M_{hd}$ le couple de rappel hydrostatique exercée sur le moyen mobile, et
$M_u$ le couple exercé par la machine de conversion sur le moyen mobile.

Ce modèle traduit un mouvement de rotation autour d'un axe horizontal (typique des flotteurs ayant un mouvement de tangage). Ce modèle est dérivé de la théorie linéaire des vagues. Ce modèle est le « miroir » du modèle pour lequel on considère les efforts : les différents termes du modèle sont de même nature.

De la même manière que pour la force de rappel hydrostatique, le couple de rappel hydrostatique peut être approximé par une fonction linéaire, ou par une fonction affine par morceaux.

Dans la suite de la description, seul le cas relatif aux efforts sera illustré, mais le cas des couples peut se déduire par transposition des équations dans un référentiel angulaire.

5) Détermination de la force d'excitation exercée par la houle incidente

Lors de cette étape, on détermine, en temps réel, la force d'excitation exercée par la houle incidente sur le moyen mobile au moyen :

- des mesures de position et de vitesse (et éventuellement d'accélération) du moyen mobile,
- de la mesure de la force exercée par la machine de conversion PTO sur le moyen mobile,
- du modèle de la force de radiation, et
- du modèle de dynamique du système houlomoteur.

Selon un premier mode de réalisation de l'invention (décrit en détail dans la suite), on peut déterminer la force d'excitation exercée par la houle incidente sur le moyen mobile sur la base du calcul d'une approximation de la force de radiation. Ce mode de réalisation présente l'avantage de permettre la prise en compte d'une représentation de la force de rappel hydrostatique par une fonction affine par morceaux.

Selon un deuxième mode de réalisation de l'invention (décrit en détail dans la suite), on peut déterminer la force d'excitation exercée par la houle incidente sur le moyen mobile au moyen d'un observateur d'état basé sur un filtre de Kalman linéaire construit à partir d'un modèle de marche aléatoire de la force d'excitation exercé par la houle incidente sur le moyen mobile. Ce deuxième mode de réalisation présente l'avantage de prendre en compte en compte des incertitudes.

Selon un troisième mode de réalisation de l'invention (décrit en détail dans la suite), on peut déterminer la force d'excitation exercée par la houle incidente sur le moyen mobile au moyen d'un estimateur d'état d'entrée inconnue basé sur une approche à horizon glissant. Ce mode de réalisation présente l'avantage de prendre en compte des incertitudes. De plus, il permet la prise en compte d'une représentation de la force de rappel hydrostatique par une fonction affine par morceaux.

D'autres modes de réalisation peuvent être envisagés.

Premier mode de réalisation

Selon le premier mode de réalisation de l'invention, on peut déterminer la force d'excitation exercée par la houle incidente sur le moyen mobile sur la base du calcul d'une approximation de la force de radiation.

Pour ce mode de réalisation, on mesure également l'accélération du moyen mobile. Préalablement à cette étape, on connaît donc :

- les mesures de position z, de vitesse $\dot{z}$ et d'accélération $\ddot{z}$ du moyen mobile,
- la mesure de la force $F_u$ exercée par la machine de conversion PTO sur le moyen mobile,

- le modèle de la force de radiation $F_{rad}(t) = -M_\infty \ddot{z}(t) - F_r(t)$ avec $F_r(t) = \int_0^t h(t-\tau)\dot{z}(\tau)d\tau,$ et

- le modèle de dynamique du système houlomoteur $M\ddot{z}(t) = F_{ex}(t) + F_{hd}(t) + F_{rad}(t) - F_u(t)$.

Ainsi si l'on sait calculer $F_r$ on peut alors obtenir $F_{rad}$, et finalement $F_{ex}(t)$, seule inconnue du modèle de la dynamique du système houlomoteur.

Mais il est n'est pas aisé de réaliser le calcul du produit de convolution dans le domaine temporel dans l'expression précédente pour $F_r(t)$, à cause du grand nombre d'opérations mathématiques à réaliser et de données à stocker. Pour l'éviter, on peut la considérer comme un système linéaire avec $F_r(t)$ en sortie et $\dot{z}(\tau)$ en entrée. L'équation résultante dans le domaine fréquentiel (de Laplace), obtenue en appliquant la méthode de Prony, est :

$$F_r(s) = W_r(s)\dot{z}(s)$$

où $W_r(s)$ est une fonction de transfert. Il est possible de mettre l'équation précédente, qui était dans le domaine de Laplace, sous une forme d'état équivalente, par exemple :

$$\begin{cases} \dot{x}_r(t) = A_r x_r(t) + B_r \dot{z}(t) \\ F_r(t) = C_r x_r(t) + D_r z(t) \end{cases}$$

où $x_r$ est un état interne n'ayant pas de signification physique particulière et $(A_r, B_r, C_r, D_r)$ sont les matrices de la réalisation d'état. On rappelle qu'en théorie des systèmes (et en automatique), une représentation d'état permet de modéliser un système dynamique sous une forme matricielle, en utilisant des variables d'état. Cette représentation peut être linéaire ou non, continue ou discrète. La représentation permet de déterminer l'état interne et les sorties du système à n'importe quel instant futur si l'on connaît l'état à l'instant initial et le comportement des variables d'entrée qui influent sur le système.

La forme d'état permet d'exprimer l'évolution dans le temps de $F_r$ comme il suit :

$$F_r(t) = C_r e^{tA_r} x_r(0) + C_r \int_0^t e^{(t-\tau)A_r} B_r \dot{z}(\tau)\, d\tau + D_r \dot{z}(t)$$

mais cette expression ne peut pas être utilisée directement car la valeur initiale de l'état interne $x_r(0)$ est inconnue. On peut toutefois approximer l'évolution temporelle $F_r$ comme il suit :

$$F_r(t) = C_r \int_0^t e^{(t-\tau)A_r} B_r \dot{z}(\tau)\, d\tau + D_r \dot{z}(t)$$

puisque $C_r e^{tA_r} x_r(0) \approx 0$ pour $t$ suffisamment large, étant donné que la matrice $A_r$ est asymptotiquement stable pour ce type de systèmes. Ce qui correspond à négliger la contribution de l'état initial à l'évolution temporelle de $F_r$, sachant qu'elle va s'estomper très rapidement par rapport à la contribution liée à la vitesse $\dot{z}$.

Le premier mode de réalisation consiste donc à calculer $F_{ex}$ à partir de $z, \dot{z}, \ddot{z}$ et $F_u$ (connus) à partir d'une équation de la forme :

$$\hat{F}_{ex}(t) = (M + M_\infty)\ddot{z}(t) + C_r \int_0^t e^{(t-\tau)A_r} B_r \dot{z}(\tau)\, d\tau + D_r \dot{z}(t) + Kz(t) + F_u(t)$$

si l'on utilise un modèle linéaire pour la force de rappel hydrostatique, ou

$$\hat{F}_{ex}(t) = (M + M_\infty)\ddot{z}(t) + C_r \int_0^t e^{(t-\tau)A_r} B_r \dot{z}(\tau)\, d\tau + D_r \dot{z}(t) + F_i z(t) + G_i + F_u(t)$$

pour chaque intervalle $\Omega_i$ auquel $z$ appartient, si on utilise un modèle affine par morceaux pour la force de rappel hydrostatique.

Puisque dans la pratique, les mesures de $z, \dot{z}, \ddot{z}$ et $F_u$ sont des signaux échantillonnés, on peut développer l'algorithme dans le temps discret $k$, en discrétisant comme il suit l'équation d'état introduite précédemment pour représenter l'évolution de $F_r$ :

$$\begin{cases} x_r(k+1) = A_{rd}x_r(k) + B_{rd}\dot{z}(k) \\ F_r(k) = C_{rd}x_r(k) + D_{rd}\dot{z}(k) \end{cases}$$

$F_r$ peut être ainsi donné par une équation de la forme :

$$F_r(k) = C_{rd}A_{rd}^k x_r(0) + \sum_{l=0}^{k-1} C_{rd}\, A_{rd}^{k-1-l} B_{rd}\dot{z}(l) + D_{rd}\dot{z}(k)$$

et son approximation par la formule:

$$F_r(k) = \sum_{l=0}^{k-1} C_{rd}\, A_{rd}^{k-1-l} B_{rd}\dot{z}(l) + D_{rd}\dot{z}(k)$$

Ce qui donne (pour le cas où la force de rappel hydrostatique est considérée affine par morceaux) l'expression suivante :

$$\hat{F}_{ex}(k) = (M + M_\infty)\ddot{z}(k) + \sum_{l=0}^{k-1} C_{rd}\, A_{rd}^{k-1-l} B_{rd}\dot{z}(l) + D_{rd}\dot{z}(k) + F_i z(k) + G_i + F_u(k)$$

pour chaque intervalle $\Omega_i$ auquel $z(k)$ appartient.

L'aspect original de ce mode de réalisation est l'approximation de la réponse temporelle de $F_r$, l'amortissement de radiation (la composante de la force de radiation dépendante de la vitesse du flotteur), calculée en passant par une représentation d'état équivalente et en négligeant la contribution de l'état initial de cette représentation.

*Deuxième mode de réalisation*

Selon un deuxième mode de réalisation de l'invention, on peut déterminer la force d'excitation exercée par la houle incidente sur le moyen mobile au moyen d'un observateur d'état basé sur un filtre de Kalman linéaire construit à partir d'un modèle de marche aléatoire de la force d'excitation exercée par la houle incidente sur le moyen mobile. On rappelle qu'un observateur d'état, ou un estimateur d'état, est, en automatique et en théorie des systèmes, une extension d'un modèle représenté sous forme de représentation d'état. Lorsque l'état du système n'est pas mesurable, on construit un observateur qui permet de reconstruire l'état à partir d'un modèle.

Pour ce mode de réalisation, préalablement à cette étape, on connaît donc :

- les mesures de position z, et de vitesse ż du moyen mobile,
- la mesure de la force $F_u$ exercée par la machine de conversion PTO sur le moyen mobile,
- le modèle de la force de radiation $F_{rad}(t) = -M_\infty\ddot{z}(t) - F_r(t)$ avec $F_r(t) = \int_0^t h(t-\tau)\dot{z}(\tau)d\tau$, et
- le modèle de dynamique du système houlomoteur $M\ddot{z}(t) = F_{ex}(t) + F_{hd}(t) + F_{rad}(t) - F_u(t)$.

Dans cette approche, le problème d'estimation de la force d'excitation de la houle est transformé en un problème classique d'estimation d'état (qui peut être résolu avec un filtre de Kalman linéaire), en exprimant la dynamique de la force d'excitation de la houle par un modèle de marche aléatoire. L'avantage principal de cette méthode est la prise en compte d'incertitudes permettant de prendre en compte les bruits de mesure et les dynamiques non modélisées.

En remplaçant dans l'équation qui décrit le mouvement du flotteur

$$M\ddot{z}(t) = F_{ex}(t) + F_{hd}(t) + F_{rad}(t) - F_u(t)$$

les expressions pour la force de rappel hydrostatique (avec le modèle linéaire) et le modèle de la force de radiation

$$F_{hd}(t) = -Kz(t)$$

$$F_{rad}(t) = -M_\infty \ddot{z}(t) - F_r(t)$$

on obtient

$$(M + M_\infty)\ddot{z}(t) + Kz(t) + F_r(t) = F_{ex}(t) - F_u(t)$$

Cette équation peut être mise sous forme d'état, en définissant

$$\begin{cases} x_1(t) = z(t) \\ x_2(t) = \dot{z}(t) \end{cases}$$

ce qui donne

$$\begin{cases} \dot{x}_1(t) = x_2(t) \\ \dot{x}_2(t) = -\dfrac{K}{M + M_\infty} x_1(t) - \dfrac{1}{M + M_\infty} F_r(t) + \dfrac{1}{M + M_\infty} (F_{ex}(t) - F_u(t)) \end{cases}$$

Comme pour le premier mode de réalisation, la dynamique de l'amortissement de radiation $F_r(t)$ peut être décrite par une représentation d'état équivalente au produit de convolution entre la réponse impulsionnelle de l'amortissement de radiation et la vitesse du moyen mobile.

$$F_r(t) = \int_0^t h(t - \tau)\dot{z}(\tau)d\tau$$

soit

$$\begin{cases} \dot{x}_r(t) = A_r x_r(t) + B_r \dot{z}(t) \\ F_r(t) = C_r x_r(t) + D_r \dot{z}(t) \end{cases}$$

ou

$$\begin{cases} \dot{x}_r(t) = A_r x_r(t) + B_r x_2(t) \\ F_r(t) = C_r x_r(t) + D_r x_2(t) \end{cases}$$

où $x_r$ est un état interne (non mesurable) n'ayant pas de signification physique particulière, et $(A_r, B_r, C_r, D_r)$ sont les matrices de la réalisation d'état.
En combinant les deux représentations d'état, on obtient :

$$\begin{cases} \dot{x}_1(t) = x_2(t) \\ \dot{x}_2(t) = -\dfrac{K}{M + M_\infty} x_1(t) - \dfrac{D_r}{M + M_\infty} x_2(t) - \dfrac{C_r}{M + M_\infty} x_r(t) + \dfrac{1}{M + M_\infty} (F_{ex}(t) - F_u(t)) \\ \dot{x}_r(t) = B_r x_2(t) + A_r x_r(t) \end{cases}$$

ou, de manière équivalente

$$\begin{cases} \dot{x}(t) = A_c x(t) + B_c(F_{ex}(t) - F_u(t)) \\ y(t) = C_c x(t) \end{cases}$$

où

$$x(t) = \begin{bmatrix} x_1(t) & x_2(t) & x_r^T(t) \end{bmatrix}^T$$

$$y = \begin{bmatrix} x_1(t) \\ x_2(t) \end{bmatrix}$$

et

$$A_c = \begin{bmatrix} 0 & 1 & 0 \\ -\dfrac{K}{M + M_\infty} & -\dfrac{D_r}{M + M_\infty} & -\dfrac{C_r}{M + M_\infty} \\ 0 & B_r & A_r \end{bmatrix}, \qquad B_c = \begin{bmatrix} 0 \\ \dfrac{1}{M + M_\infty} \\ 0 \end{bmatrix}, \qquad C_c = \begin{bmatrix} 1 & 0 & 0 \\ 0 & 1 & 0 \end{bmatrix}$$

On doit estimer $F_{ex}(t)$ en utilisant $y(t)$ (le vecteur qui contient les mesures de la position et de la vitesse du moyen mobile) et $F_u(t)$, la mesure de la force du PTO.

Pour ce faire, on discrétise d'abord le système d'état ci-dessus (on rappelle que les mesures sont échantillonnées), avec la méthode de Tustin. Ce qui donne

$$\begin{cases} x(k+1) = A_d x(k) + B_d(F_{ex}(k) - F_u(k)) \\ y(k) = C_d x(k) + B_d(F_{ex}(k) - F_u(k)) \end{cases}$$

On note qu'il est important d'effectuer la discrétisation avec la méthode de Tustin, car elle fait apparaître un terme direct dans l'équation de sortie qui permet de relier $y(k)$ à $F_{ex}(k)$, et donc d'estimer $F_{ex}(k)$ en utilisant $y(k)$. Cela ne serait pas possible avec d'autres méthodes de discrétisation, qui relieraient $y(k)$ à $F_{ex}(k - 1)$ et non pas à $F_{ex}(k)$.

En définissant

$$w(k) = F_{ex}(k), \ \ u(k) = F_u(k),$$

il résulte le modèle global de la dynamique du flotteur :

$$\begin{cases} x(k+1) = A_d x(k) + B_d w(k) - B_d u(k) \\ y(k) = C_d x(k) + D_d w(k) - D_d u(k) \end{cases}$$

Pour estimer la force d'excitation $w(k)$, on la considère comme un état, dont on définit l'évolution en introduisant un modèle mathématique qui relie $w(k)$ à $w(k - 1)$.

Pour ce mode de réalisation, on utilise un modèle de marche aléatoire pour décrire l'évolution de la force d'excitation :

$$w(k + 1) = w(k) + \epsilon_m(k)$$

où $\varepsilon_m(k)$, qui décrit la variation de $w(k)$, est considéré comme un nombre aléatoire. En d'autres termes, ce modèle suppose qu'à chaque instant $k$, la force d'excitation s'éloigne d'un pas (d'une quantité) aléatoire de sa valeur précédente, et que ces pas sont distribués indépendamment et identiquement en taille.

On couple alors ce modèle de marche aléatoire de la force d'excitation à un modèle de la dynamique du flotteur :

$$\begin{cases} x(k + 1) = A_d x(k) + B_d w(k) - B_d u(k) + \epsilon_x(k) \\ y(k) = C_d x(k) + D_d w(k) - D_d u(k) + \mu(k) \end{cases}$$

plus robuste vis-à-vis des erreurs de modélisation, grâce à l'introduction de $\varepsilon_x(k)$ qui représente les dynamiques non modélisées (frottements du PTO, non-linéarité hydrostatique, ...) et $\mu(k)$ qui décrit les bruits de mesure sur la position et la vitesse du flotteur.

En combinant le modèle de marche aléatoire de la force d'excitation de la houle incidente et la dynamique du flotteur, on obtient le système d'état augmenté :

$$\begin{cases} x(k + 1) = A_d x(k) + B_d w(k) - B_d u(k) + \epsilon_x(k) \\ w(k + 1) = w(k) + \epsilon_m(k) \\ y(k) = C_d x(k) + D_d w(k) - D_d u(k) + \mu(k) \end{cases}$$

ou, de manière équivalente,

$$\begin{cases} x_a(k + 1) = A_a x_a(k) + B_a u(k) + \epsilon(k) \\ y(k) = C_a x_a(k) + D_a u(k) + \mu(k) \end{cases}$$

où

$$x_a(k) = \begin{bmatrix} x(k) \\ w(k) \end{bmatrix}, \quad \epsilon(k) = \begin{bmatrix} \epsilon_x(k) \\ \epsilon_m(k) \end{bmatrix}$$

et

$$A_a = \begin{bmatrix} A_d & B_d \\ 0 & 1 \end{bmatrix}, B_a = \begin{bmatrix} -B_d \\ 0 \end{bmatrix}, C_a = [C_d \quad D_d], \ D_a = -D_d$$

Ainsi, le problème d'estimation de $w(k)$, devient un problème d'estimation d'état.

Une manière d'estimer le vecteur d'état inconnu $x_a(k)$, en prenant en compte des informations sur $\varepsilon(k)$ et $\mu(k)$, est d'appliquer l'algorithme du filtre de Kalman linéaire, comme montré par la suite. Une alternative peut être d'utiliser l'approche d'estimation à horizon glissant (la même utilisée dans le troisième mode de réalisation pour estimer la force d'excitation, vue cette fois-ci comme une entrée inconnue).

L'algorithme du filtre de Kalman linéaire (KF) fournit la solution du problème d'optimisation suivant :

$$\min_{x_a(k)} \left\{ (x_a(0) - \bar{x}_a(0))^T P_0^{-1} (x_a(0) - \bar{x}_a(0)) + \sum_{j=1}^{k} \epsilon(j - 1)^T Q^{-1} \epsilon(j - 1) + \mu(j)^T R^{-1} \mu(j) \right\}$$

où $P_0$, $Q$, et $R$ sont des matrices de calibration de dimensions appropriées, $\bar{x}_a(0)$ est la valeur moyenne de l'état initial $x_a(0)$.

En considérant $x_a(0)$ comme un vecteur aléatoire, non corrélé à $\varepsilon(k)$ et $\mu(k)$, de moyenne $\bar{x}_a(0)$ avec matrice de covariance $P_0$, et $\varepsilon(k)$ et $\mu(k)$ comme deux processus aléatoires de type bruit blanc avec moyenne nulle avec matrices de covariance $Q$ et $R$ respectivement, on peut résoudre le problème d'optimisation avec l'algorithme du filtre de Kalman linéaire.

À chaque instant $k$, l'algorithme du filtre de Kalman linéaire calcule la solution à ce problème en passant par deux étapes.

La première étape est la mise à jour temporelle des estimations :

$$\begin{cases} \hat{x}_a(k|k - 1) = A_a \hat{x}_a(k - 1|k - 1) + B_a F_u(k - 1) \\ P(k|k - 1) = A_a P(k - 1|k - 1) A_a^T + Q \end{cases}$$

où $\hat{x}_a(k|k - 1)$ et $P(k|k - 1)$ sont respectivement l'estimation de $x_a(k)$ et sa matrice de covariance obtenues en utilisant les mesures à partir de l'instant $k - 1$ (soit $y(k - 1), y(k - 2)$, ... et $F_u(k - 1)$, $F_u(k - 2),...$), et $\hat{x}_a(k|k)$ et $P(k|k)$ sont l'estimation de $x_a(k)$ et sa matrice de covariance obtenues en utilisant les mesures à partir de l'instant $k$ (soit $y(k)$, $y(k - 1)$, ... et $F_u(k)$, $F_u(k - 1),...$).

La seconde étape est la mise à jour des mesures :

$$\begin{cases} K(k) = P(k|k - 1)C_a^T(C_a P(k|k - 1)C_a^T + R)^{-1} \\ \hat{x}_a(k|k) = \hat{x}_a(k|k - 1) + K(k)(y(k) - C_a\hat{x}_a(k|k - 1) - D_a M_u(k)) \\ P(k|k) = (I - K(k)C_a(k))P(k|k - 1) \end{cases}$$

Avec K(k) le gain de l'observateur, qui est un vecteur de paramètres qui pondère les erreurs entre les estimations et les mesures des sorties du système (position et vitesse). Dans le cas du filtre de Kalman, ce n'est pas un paramètre de calibration, mais il est issu de l'estimation de la matrice de covariance.

En résumant, pour le deuxième mode de réalisation, on peut mettre en œuvre les étapes suivantes :

- On initialise $k = 0$, $\hat{x}_a(0|0) = \overline{x}_a(0)$, $P(0|0) = P_0$
- À chaque instant $k$ :

    - on utilise :

        - les mesures de la position et de la vitesse du moyen mobile $y(k) = [z(k)\ \dot{z}(k)]$ et de la force exercée par le PTO sur le moyen mobile $u(k) = F_u(k)$
        - les résultats des estimations du pas précédent $\hat{x}_a(k - 1|k - 1)$, P($k - 1|k - 1$)
        - les paramètres $Q$, $R$ (matrices de covariance)

    - on détermine la force d'excitation $F_{ex}$ exercée par la houle incidente sur le moyen mobile, noté pour ce mode de réalisation $\hat{w}(k)$, en mettant en œuvre les étapes suivantes :

        - on applique les deux étapes de l'algorithme du filtre de Kalman linéaire pour obtenir $\hat{x}_a(k|k)$, P($k|k$), ainsi on estime l'état complet avec sa matrice de covariance :

$$\begin{cases} \hat{x}_a(k|k - 1) = A_a\hat{x}_a(k - 1|k - 1) + B_a F_u(k - 1) \\ P(k|k - 1) = A_a P(k - 1|k - 1)A_a^T + Q \end{cases},$$

$$K(k) = P(k|k - 1)C_a^T(C_a P(k|k - 1)C_a^T + R)^{-1}$$

        ○ $\hat{x}_a(k|k) = \hat{x}_a(k|k - 1) + K(k)(y(k) - C_a\hat{x}_a(k|k - 1) - D_a F_u(k))$ P($k|k$) = ($I - K(k)C_a(k))P(k|k - 1)$

$$x_a(k) = \begin{bmatrix} x(k) \\ w(k) \end{bmatrix},$$

        avec $x_a(k)$ le vecteur d'état inconnu $A_a, B_a, C_a, D_a$ des matrices de la réalisation d'état, P la matrice de covariance du vecteur d'état, Q et R des matrices de calibration.

    - et on extrait la dernière composante du vecteur d'état estimé, c'est-à-dire la force d'excitation $F_{ex}$ exercée par la houle incidente sur le moyen mobile par une équation de la forme : $\hat{w}(k) = [0\ 1]\ \hat{x}_a(k|k)$

*Troisième mode de réalisation*

Selon le troisième mode de réalisation de l'invention, on peut déterminer la force d'excitation exercé par la houle incidente sur le moyen mobile au moyen d'un estimateur d'état à entrée inconnue basé sur une approche d'horizon glissant. L'estimation à horizon glissant est un algorithme qui détermine récursivement l'état et l'entrée inconnue en utilisant des données appartenant à une fenêtre temporelle finie.

Pour ce mode de réalisation, préalablement à cette étape, on connaît donc :

- les mesures de position z, de vitesse $\dot{z}$ du moyen mobile,
- la mesure de la force $F_u$ exercée par la machine de conversion PTO sur le moyen mobile,

- le modèle de la force de radiation $F_{rad}(t) = -M_\infty \ddot{z}(t) - F_r(t)$ avec $F_r(t) = \int_0^t h(t-\tau)\dot{z}(\tau)d\tau,$ et
- le modèle de dynamique du système houlomoteur $\ddot{z}(t) = F_{ex}(t) + F_{hd}(t) + F_{rad}(t) - F_u(t).$

Le deuxième mode de réalisation est complètement linéaire, et ne permet pas de prendre en compte directement une description non linéaire (plus précise) de la force de rappel hydrostatique.

Ce troisième mode de réalisation permet de s'affranchir de cette limitation. À la différence du deuxième mode de réalisation, la force d'excitation n'est plus considérée comme un état du modèle global qui représente la dynamique du flotteur, dont l'évolution est décrite par un modèle de marche aléatoire, mais est considérée comme une entrée inconnue d'un modèle global (légèrement différent) représentant la dynamique du flotteur.

En combinant l'équation qui décrit le mouvement du flotteur selon la théorie linéaire des vagues

$$M\ddot{z}(t) = F_{ex}(t) + F_{hd}(t) + F_{rad}(t) - F_u(t)$$

et l'expression pour la force de radiation

$$F_{rad}(t) = -M_\infty \ddot{z}(t) - F_r(t)$$

on obtient

$$(M + M_\infty)\ddot{z}(t) + F_r(t) = w(t) + u_d(t)$$

où $w(t) = F_{ex}(t)$ et $u_d(t) = F_{hd}(t) - F_u(t)$. On considère $u_d(t)$ comme une entrée de contrôle du système décrit, connue car $F_u(t)$ est mesurable et $F_{hd}(t)$ peut se calculer à partir d'un modèle (linéaire ou non linéaire) de la force de rappel hydrostatique, tandis que $w(t)$ est une entrée (une perturbation) inconnue.

Cette équation peut être mise sous forme d'état, en définissant

$$\begin{cases} x_1(t) = z(t) \\ x_2(t) = \dot{z}(t) \end{cases}$$

ce qui donne

$$\begin{cases} \dot{x}_1(t) = x_2(t) \\ \dot{x}_2(t) = -\dfrac{1}{M + M_\infty}F_r(t) + \dfrac{1}{M + M_\infty}(w(t) - u_d(t)) \end{cases}$$

Comme pour le deuxième mode de réalisation, en partant de

$$F_r(t) = \int_0^t h(t-\tau)\dot{z}(\tau)d\tau$$

on peut exprimer l'amortissement de radiation $F_r(t)$ comme la sortie d'un système linéaire sous forme de représentation d'état dont l'entrée est $x_2(t) = \dot{z}(t)$

soit

$$\begin{cases} \dot{x}_r(t) = A_r x_r(t) + B_r \dot{z}(t) \\ F_r(t) = C_r x_r(t) + D_r \dot{z}(t) \end{cases}$$

soit

$$\begin{cases} \dot{x}_r(t) = A_r x_r(t) + B_r x_2(t) \\ F_r(t) = C_r x_r(t) + D_r x_2(t) \end{cases}$$

où $x_r$ est un état interne (non mesurable) n'ayant pas de signification physique particulière et $(A_r, B_r, C_r, D_r)$ sont les matrices de la réalisation d'état.

En combinant les deux représentations d'état, on obtient :

$$\begin{cases} \dot{x}_1(t) = x_2(t) \\ \dot{x}_2(t) = -\dfrac{D_r}{M + M_\infty} x_2(t) - \dfrac{C_r}{M + M_\infty} x_r(t) + \dfrac{1}{M + M_\infty}(w(t) + u_d(t)) \\ \dot{x}_r(t) = B_r x_2(t) + A_r x_r(t) \end{cases}$$

ou, de manière équivalente

$$\begin{cases} \dot{x}(t) = A_c x(t) + B_c(w(t) + u_d(t)) \\ y(t) = C_c x(t) \end{cases}$$

où

$$x(t) = \begin{bmatrix} x_1(t) & x_2(t) & x_r^T(t) \end{bmatrix}^T$$

$$y = \begin{bmatrix} x_1(t) \\ x_2(t) \end{bmatrix}$$

et

$$A_c = \begin{bmatrix} 0 & 1 & 0 \\ 0 & -\dfrac{D_r}{M + M_\infty} & -\dfrac{C_r}{M + M_\infty} \\ 0 & B_r & A_r \end{bmatrix}, \quad B_c = \begin{bmatrix} 0 \\ \dfrac{1}{M + M_\infty} \\ 0 \end{bmatrix}, \quad C_c = \begin{bmatrix} 1 & 0 & 0 \\ 0 & 1 & 0 \end{bmatrix}$$

On cherche à estimer $w(t)$ en utilisant $y(t)$ (le vecteur qui contient les mesures de la position et de la vitesse du flotteur) et $u_d(t)$. On rappelle que $u_d(t) = F_{hd}(t) - F_u(t)$ et qu'on peut utiliser, par exemple, l'approximation affine par morceaux, pour calculer la force de rappel hydrostatique :
$F_{hd} = -F_i z(t) - G_i$ pour chaque intervalle $\Omega_i$, auquel $z$ appartient.
Pour ce faire, on peut d'abord discrétiser le système d'état ci-dessus (on rappelle que les mesures sont échantillonnées), avec la méthode de Tustin. Ce qui donne

$$\begin{cases} x(k + 1) = A_d x(k) + B_d w(k) + B_d u_d(k) \\ y(k) = C_d x(k) + D_d w(k) + D_d u_d(k) \end{cases}$$

Puis rendre le modèle plus réaliste en rajoutant des incertitudes (des bruits) sur l'état et la sortie :

$$\begin{cases} x(k + 1) = A_d x(k) + B_d w(k) + B_d u_d(k) + \epsilon(k) \\ y(k) = C_d x(k) + D_d w(k) + D_d u_d(k) + \mu(k) \end{cases}$$

où $\varepsilon(k)$ et $\mu(k)$ sont des bruits blancs de moyenne nulle.
Pour estimer l'entrée inconnue $w(k)$ (et accessoirement l'état $x(k)$) on utilise la méthode d'estimation à horizon glissant (en anglais « *moving-horizon estimation* », MHE). Le problème consiste à estimer, à chaque instant de temps $k \geq N$ le vecteur d'état $x(k)$ et l'entrée inconnue $w(k) = F_{ex}(k)$, sur la base :

- d'estimations a priori: $\hat{x}(k - N|k - 1)$, $\hat{w}(k - N|k - 1)$ (respectivement les estimations de $x(k - N)$ et $\hat{w}(k - N)$) en utilisant les mesures à partir du temps $k$ - 1 ;
- d'informations sur les sorties : $y(k - N)$, $y(k - N + 1)$, ..., $y(k)$ ; et
- d'informations sur l'entrée connue : $u_d(k - N)$, $u_d(k - N + 1)$,...,$u_d(k)$

Soient :

$$\hat{x}_0 = \hat{x}(k - N|k - 1)$$

$$\hat{w}_0 = \hat{w}(k - N|k - 1)$$

et :

$$x_j = \hat{x}(k - N + j|k)$$

$$w_j = \hat{w}(k - N + j|k)$$

$$\epsilon_j = \hat{e}(k - N + j|k)$$

pour $j = 0,1,...,N$.

Le problème d'estimation à horizon glissant est formulé comme :

$$\min_{x_0,w_0,w_1,...,\epsilon_1,...,\epsilon_N} J(x_0, w_0, w_1, ..., \epsilon_1, ..., \epsilon_N)$$

avec la fonction objectif (coût) suivante

$$J(\cdot) = \|x_0 - \hat{x}_0\|_{P_0^{-1}}^2 + \|w_0 - \hat{w}_0\|_{Q_0^{-1}}^2 + \sum_{j=0}^{N-1} \|\epsilon_j\|_{Q^{-1}}^2 +$$

$$+ \sum_{j=0}^{N} \|y(k - N + j) - \hat{y}(k - N + j)\|_{R^{-1}}^2 + \sum_{j=0}^{N-1} \|w_j - w_{j-1}\|^2$$

où

$$\hat{y}(k - N + j) = C_d x_j + D_d w_j + D_d u_d(k - N + j)$$

La notation $\|v\|_M^2$ indique le produit $v^T M v$ pour un vecteur de réels $v$ et une matrice symétrique de réels $M$.

Il y a cinq termes dans la fonction coût :

- Le premier terme $\|x_0 - \hat{x}_0\|_{P_0^{-1}}^2$ et le deuxième terme $\|w_0 - \hat{w}_0\|_{Q_0^{-1}}^2$ sommés ensemble forment le « coût d'arrivée », qui résume l'information préalable au temps $k$ - $N$ et fait partie des données du problème d'estimation.
- Le troisième terme et le quatrième terme pénalisent les bruits de procédé et de mesure respectivement avec les matrices de pondération $Q$ et $R$.
- Le dernier terme est un terme de régularisation qui sert à prendre en compte le fait que la force d'excitation de la houle est un signal régulier (lisse).

Ce dernier terme est important pour déterminer la force exercée par la houle de manière optimale. Une autre manière de prendre en compte la nature « lisse » de la force d'excitation de la houle consisterait à lui imposer des contraintes de variation.

En utilisant la démarche classique de l'estimation et de la commande à horizon glissant, la minimisation de la fonction coût peut être transformée en un problème de programmation quadratique QP (on rappelle qu'un problème de programmation quadratique est un problème d'optimisation dans lequel on minimise/maximise une fonction quadratique sur un polyèdre convexe) en propageant :

$$\begin{cases} x(k+1) = A_d x(k) + B_d w(k) + B_d u_d(k) + \epsilon(k) \\ y(k) = C_d x(k) + D_d w(k) + D_d u_d(k) + \mu(k) \end{cases}$$

dans le temps. Ce qui donne :

$$
\begin{aligned}
x_1 \;&= A_d x_0 + B_d w_0 + B_d u_d(k-N) + \epsilon_0 \\
x_2 \;&= A_d x_1 + B_d w_1 + B_d u_d(k-N+1) + \epsilon_1 \\
&= A_d^2 x_0 + A_d B_d w_0 + B_d w_1 + A_d B_d u_d(k-N) + B_d u_d(k-N+1) + A_d \epsilon_0 + \epsilon_1 \\
&\;\vdots \\
x_n \;&= A_d^N x_0 + A_d^{N-1} B_d w_0 + \cdots + B_d w_{N-1} + A_d^{N-1} B_d u_d(k-N) + \cdots \\
&\quad + B_d u_d(k-1) + A_d^{N-1} \epsilon_0 + \cdots + \epsilon_1
\end{aligned}
$$

ou, en forme compacte,

$$X = \Phi_x x_0 + \Psi_x W + \Psi_x U_d + \Gamma_x E$$

où

$$
X = \begin{bmatrix} x_1 \\ x_2 \\ \vdots \\ x_N \end{bmatrix}, W = \begin{bmatrix} w_1 \\ w_2 \\ \vdots \\ w_N \end{bmatrix}, U_d = \begin{bmatrix} u_d(k-N) \\ u_d(k-N+1) \\ \vdots \\ u_d(k) \end{bmatrix}, E = \begin{bmatrix} \epsilon_1 \\ \epsilon_2 \\ \vdots \\ \epsilon_N \end{bmatrix}
$$

et

$$
\Phi_x = \begin{bmatrix} A_d \\ A_d^2 \\ \vdots \\ A_d^N \end{bmatrix}, \Psi_x = \begin{bmatrix} B_d & 0 & \cdots & 0 & 0 \\ A_d B_d & B_d & \cdots & 0 & 0 \\ \vdots & \vdots & \ddots & \vdots & \vdots \\ A_d^{N-1} B_d & A_d^{N-2} B_d & \cdots & B_d & 0 \end{bmatrix}, \Gamma_x = \begin{bmatrix} I & 0 & \cdots & 0 \\ A_d & I & \cdots & 0 \\ \vdots & \vdots & \ddots & \vdots \\ A_d^{N-1} & A_d^{N-2} & \cdots & I \end{bmatrix}
$$

En appliquant la même démarche à l'équation de sortie, et en introduisant les notations

$$Y = \begin{bmatrix} y(k-N+1)^T & y(k-N+2)^T & & y(k)^T \end{bmatrix}^T,$$

$$
\Phi_y = \begin{bmatrix} C_d A_d \\ C_d A_d^2 \\ \vdots \\ C_d A_d^N \end{bmatrix}, \Psi_y = \begin{bmatrix} C_d B_d & D_d & \cdots & 0 & 0 \\ C_d A_d B_d & C_d B_d & \cdots & 0 & 0 \\ \vdots & \vdots & \ddots & \vdots & \vdots \\ C_d A_d^{N-1} B_d & C_d A_d^{N-2} B_d & \cdots & C_d B_d & D_d \end{bmatrix}, \Gamma_y
$$

$$
= \begin{bmatrix} C_d & 0 & \cdots & 0 \\ C_d A_d & C_d & \cdots & 0 \\ \vdots & \vdots & \ddots & \vdots \\ C_d A_d^{N-1} & C_d A_d^{N-2} & \cdots & C_d \end{bmatrix}
$$

on aboutit à un problème QP de la forme :

$$\begin{cases} \min_{\xi}\left\{\xi^T(\mathbf{P} + \Psi_s^T\mathbf{R}\Psi_s)\xi - 2[\widehat{w}_0^T \quad \widehat{x}_0^T \quad V^T]\begin{bmatrix}\mathbf{S}\\\mathbf{R}\Psi_s\end{bmatrix}\xi\right\} \\ \text{tel que } H_\xi\xi \leq g_\xi + H_d U_d \end{cases}$$

où

$$\begin{cases} \xi = [W^T \quad x_0^T \quad E^T] \\ V = Y - \Psi_y U_d \\ \Psi_s = [\Psi_y \quad \Phi_y \quad \Gamma_y] \end{cases}$$

avec $\xi$ une matrice qui représente l'ensemble des variables inconnues à estimer (les valeurs de l'entrée inconnue $W^T$ et de l'incertitude sur l'état $E^T$ pour tous les N pas de la fenêtre d'estimation considérée, et l'état initial $x_0^T$ au temps $k - N$), $\Psi_s$ une matrice qui englobe les effets de ces mêmes variables inconnues sur les valeurs sorties sur la fenêtre d'estimation $Y$, $\Psi_y$ une matrice qui correspond aux effets de l'entrée connue $U_d$ sur $Y$, $\Psi_y$ $\Psi_y$ et $\Psi_s$ se calculant à partir de la représentation d'état définie auparavant, et $\mathbf{P}$, $\mathbf{R}$ et $\mathbf{S}$ sont des matrices formées à partir des matrices de pondération de la fonction coût $Q, R, Q_0^{-1}, R_0^{-1}$ et du paramètre de régularisation $\lambda$ comme il suit :

$$\mathbf{Q} = \begin{bmatrix} Q^{-1} & 0 & \cdots & 0 \\ 0 & Q^{-1} & \cdots & 0 \\ \vdots & \vdots & \ddots & \vdots \\ 0 & 0 & \cdots & Q^{-1} \end{bmatrix}, \mathbf{R} = \begin{bmatrix} R^{-1} & 0 & \cdots & 0 \\ 0 & R^{-1} & \cdots & 0 \\ \vdots & \vdots & \ddots & \vdots \\ 0 & 0 & \cdots & R^{-1} \end{bmatrix},$$

$$\Lambda_1 = \begin{bmatrix} Q_0^{-1} - \lambda & \lambda & 0 & 0 & \cdots & 0 & 0 \\ 0 & -\lambda & \lambda & 0 & \cdots & 0 & 0 \\ 0 & 0 & -\lambda & \lambda & \cdots & 0 & 0 \\ \vdots & \vdots & \vdots & \vdots & \ddots & \vdots & \vdots \\ 0 & 0 & 0 & 0 & \cdots & \lambda & 0 \\ 0 & 0 & 0 & 0 & \cdots & -\lambda & \lambda \end{bmatrix}, \mathbf{P} = \begin{bmatrix} \Lambda_1 & 0 & 0 \\ 0 & P_0^{-1} & 0 \\ 0 & 0 & \mathbf{Q} \end{bmatrix}, \mathbf{S} = \begin{bmatrix} Q_0^{-1} & 0 & \cdots & 0 \\ 0 & P_0^{-1} & \cdots & 0 \end{bmatrix}$$

Pour terminer

$$H_\xi\xi \leq g_\xi + H_d U_d$$

est une inégalité linéaire qui, à l'aide des matrices $H_\xi$ et $H_d$ et du vecteur $g_\xi$, retranscrit en forme compacte des contraintes polytopiques sur l'entrée inconnue et l'état :

$$\begin{cases} w \in P_w, P_w = \{w : H_w \leq g_w\}, \quad g_w > 0 \\ x \in P_x, P_x = \{x : H_x \leq g_x\}, \quad g_x > 0 \end{cases}$$

à leur tour définies par les matrices $H_w$ et $H_x$ et les vecteurs $g_w$ et $g_x$. Cette inégalité permet de prendre en compte des informations sur les amplitudes minimales et maximales de la force d'excitation de la houle incidente, de la position et de la vitesse du flotteur.

Le problème d'estimation à horizon glissant est un problème de programmation quadratique sous contraintes que l'on peut résoudre avec des solveurs tels que FORCES ® (Embotech, Suisse) ou CVXGEN ® (CVXGEN LLC, USA) par exemple.

Soit $\xi^*$ la solution du problème de programmation dynamique obtenue avec l'un de ces solveurs. L'estimation des forces d'excitation, à partir des mesures au temps $k$, est donnée par :

$$\hat{w}(k - N + j|k) = \xi^*(j), \forall j = 1,2, \dots, N$$

En résumant, pour le troisième mode de réalisation, on peut mettre en œuvre les étapes décrites ci-dessous.

On initialise à zéro les composants des vecteurs des mesures et estimations passées correspondants au $N$-1 pas de temps précédant l'instant actuel $k = 0$

À chaque instant $k$,

1. On acquiert :

- les mesures de la position et la vitesse du moyen mobile $y(k) = [z(k) \; \dot{z}(k)]$ et de la force exercée par le PTO sur le moyen mobile $u(k) = F_u(k)$,
- les résultats des estimations du pas de temps précédent $\hat{x}_d(k - N|k - 1)$, $\hat{w}(k - N|k - 1)$
- les paramètres $Q$, $R$, $Q_0^{-1}$, $R_0^{-1}$ (matrices de pondération) et $\lambda$ (régularisation)

2. On calcule $\hat{w}(k|k)$ qui correspond à l'estimation de la force exercée par la houle sur le moyen mobile, en mettant en œuvre les étapes suivantes :

i. on résout le problème de programmation quadratique QP suivant pour obtenir la solution $\xi^*$

$$\begin{cases} \min_{\xi} \left\{ \xi^T (\mathbf{P} + \Psi_s^T \mathbf{R} \Psi_s)\xi - 2[\hat{w}_0^T \quad \hat{x}_0^T \quad V^T] \begin{bmatrix} \mathbf{S} \\ \mathbf{R}\Psi_s \end{bmatrix} \xi \right\} \\ \text{tel que } H_\xi \xi \leq g_\xi + H_d U_d \end{cases}$$

ii. on estime la force d'excitation exercée par la houle incidente sur le moyen mobile w($k$) par une équation de la forme :

$$\hat{w}(k|k) = \xi^*(N).$$

6) Commande du système houlomoteur

Lors de cette étape, on contrôle le système houlomoteur, de manière à prendre en compte la force d'excitation exercée par la houle incidente. Ainsi, il est possible de piloter le système houlomoteur, afin d'optimiser l'énergie récupérée.

La commande peut consister en un contrôle du moyen mobile du système houlomoteur, par exemple au moyen d'une machine de conversion électrique, pneumatique ou hydraulique, nommé système PTO (de l'anglais « power take-off »). Ce système PTO influence le mouvement du moyen mobile et permet de transférer l'énergie mécanique au réseau électrique, pneumatique ou hydraulique. La commande prédictive par modèle (MPC) est un exemple de méthode de commande de systèmes houlomoteurs.

Exemple illustratif

Afin de montrer l'intérêt du procédé selon l'invention, un test du procédé selon l'invention a été réalisé en bassin. Le système houlomoteur correspond au système houlomoteur illustré en figure 1. Le système houlomoteur est équipé d'un capteur de couple pour mesurer le couple exercé par la houle sur le moyen mobile. Préalablement, on détermine le couple exercée par la houle pour le cas où le contrôle est non actif (c'est-à-dire lorsque la machine de conversion ne génère pas de couple au système), et où le flotteur est maintenu à une position d'équilibre. Ces caractéristiques permettent de comparer le couple d'excitation exercé par la houle incidente sur le moyen mobile pour ce premier test, à d'autres tests lorsque le flotteur est mobile, et la machine électrique activée.

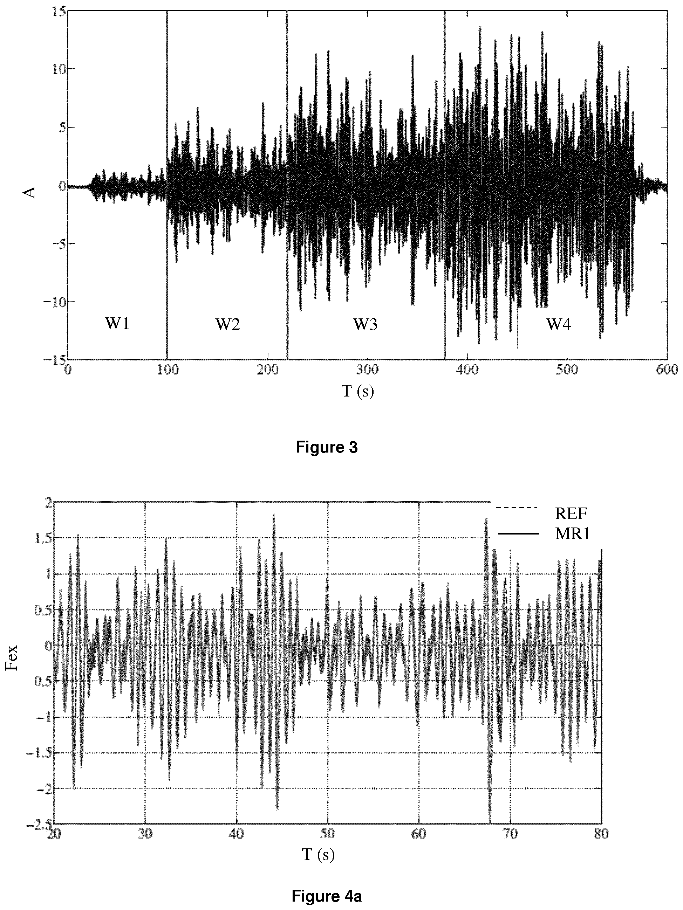

Pour la présente analyse, une concaténation de quatre types de houles différentes est considérée. Ces quatre types de houle W1, W2, W3, W4 (de l'amplitude la plus faible à l'amplitude la plus élevée) sont représentés en figure 3, qui illustre l'amplitude A en fonction du temps T.

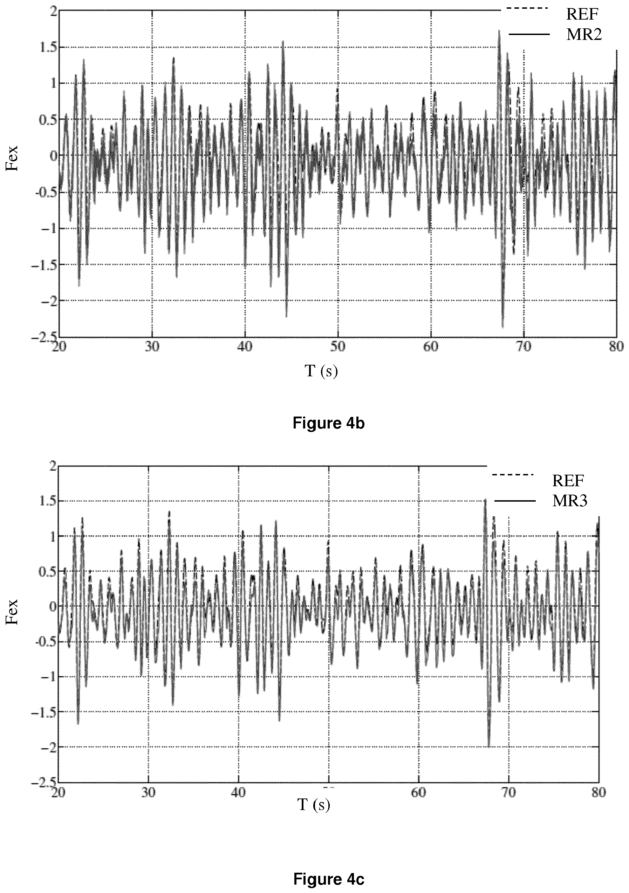

Les figures 4a à 4c représentent une comparaison de la force (dans ce cas, le couple) de référence d'excitation exercée par la houle incidente sur le moyen mobile, avec la force (dans ce cas, le couple) d'excitation exercé par la houle incidente sur le moyen mobile déterminée selon un mode de réalisation de l'invention. Les figures 4a à 4c correspondent à une houle de type W1 représentée sur la figure 3. La référence est notée REF, et est représentée par des traits pointillés. Les forces de la houle incidente déterminées par le procédé selon l'invention sont représentées par un trait continu. La figure 4a correspond au premier mode de réalisation de l'invention MR1, la figure 4b correspond au deuxième mode de réalisation de l'invention MR2, et la figure 4c correspond au troisième mode de réalisation de l'invention MR3. On remarque sur ces figures 4a à 4c, que, pour les trois modes de réalisation, la courbe représentative de la force déterminée par le procédé selon l'invention est quasiment superposée à la courbe représentant de la force de référence. Ainsi, le procédé selon l'invention permet de déterminer de manière précise la force d'excitation de la houle incidente sur le moyen mobile.

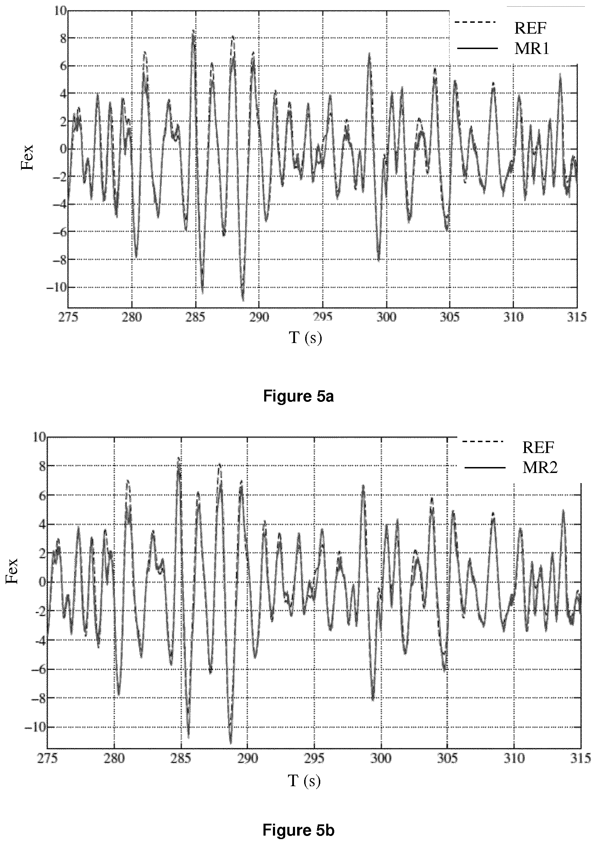

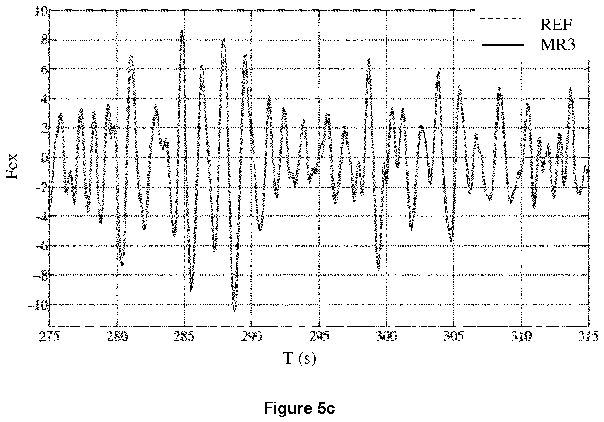

Les figures 5a à 5c représentent une comparaison de la force (dans ce cas, le couple) de référence d'excitation exercée par la houle incidente sur le moyen mobile, avec la force (dans ce cas, le couple) d'excitation exercée par la houle incidente sur le moyen mobile déterminée selon un mode de réalisation de l'invention. Les figures 5a à 5c correspondent à une houle de type W3 représentée sur la figure 3. La référence est notée REF et est représentée par des traits pointillés. Les forces de la houle déterminées par le procédé selon l'invention sont représentées par un trait continu. La figure 5a correspond au premier mode de réalisation de l'invention MR1, la figure 5b correspond au deuxième mode de réalisation de l'invention MR2, et la figure 5c correspond au troisième mode de réalisation de l'invention MR3. On remarque sur ces figures 5a à 5c, que, pour les trois modes de réalisation, la courbe représentative de la force déterminée par le procédé selon l'invention est sensiblement superposée à la courbe représentant de la force de référence. Ainsi, le procédé selon l'invention permet de déterminer de manière précise la force d'excitation de la houle incidente exercée sur le moyen mobile. On peut également observer que l'erreur entre la force de référence et la force déterminée est inférieure pour ces courbes que pour les courbes des figures 4a à 4c.

## Revendications

1. Procédé de commande d'un système houlomoteur (1) au moyen de la détermination de la force d'excitation exercée par la houle incidente sur un moyen mobile (2) dudit système houlomoteur (1), ledit système houlomoteur (1) convertissant l'énergie de la houle en énergie au moyen dudit moyen mobile (2) coopérant avec une machine de conversion (3), ledit moyen mobile (2) effectuant un mouvement par rapport à ladite machine de conversion (3) sous l'action de la houle, **caractérisé en ce qu'**on réalise les étapes suivantes :

   a) on mesure la position et la vitesse dudit moyen mobile (2) ;
   b) on mesure la force $F_u$ exercée par ladite machine de conversion (3) sur ledit moyen mobile (2) ;
   c) on construit un modèle de la force $F_{rad}$ de radiation exercée sur ledit moyen mobile (2), ledit modèle de la force $F_{rad}$ de radiation reliant ladite force de radiation à la vitesse dudit moyen mobile (2) ;
   d) on construit un modèle de dynamique dudit système houlomoteur qui relie ladite force d'excitation $F_{ex}$ exercée par la houle incidente sur ledit moyen mobile (2), à ladite position dudit moyen mobile (2), à ladite vitesse du moyen mobile (2), à ladite force $F_u$ exercée par ladite machine de conversion (3) sur ledit moyen mobile (2) et à ladite force de radiation $F_{rad}$ exercée sur ledit moyen mobile (2) ;
   e) on détermine ladite force d'excitation $F_{ex}$ exercée par la houle incidente sur ledit moyen mobile (2) au moyen dudit modèle de dynamique, dudit modèle de la force de radiation, desdites position et vitesse mesurées et de ladite force $F_u$ mesurée exercée par ladite machine de conversion (3) sur ledit moyen mobile (2) ; et
   f) on commande ledit système houlomoteur en fonction de ladite force d'excitation Fex exercée par la houle incidente sur ledit moyen mobile, déterminée (2).

2. Procédé selon la revendication 1, dans lequel on construit ledit modèle de dynamique dudit système houlomoteur au moyen d'une équation du type: $M\ddot{z}(t) = F_{ex}(t) + F_{hd}(t)+F_{rad}(t) - F_u(t)$ avec M la masse du moyen mobile, $\ddot{z}$ l'accélération dudit moyen mobile (2), $F_{hd}$ la force de rappel hydrostatique exercée sur ledit moyen mobile (2).

3. Procédé selon la revendication 2, dans lequel on détermine ladite force $F_{hd}$ de rappel hydrostatique au moyen d'une formule du type : $F_{hd}(t) = -Kz(t)$ avec z la position dudit moyen mobile et K le coefficient de raideur hydrostatique.

4. Procédé selon la revendication 2, dans lequel on détermine ladite force $F_{hd}$ de rappel hydrostatique par une fonction affine par morceau du type : $F_{hd} = -F_i z(t) - G_i$ pour au moins deux intervalles $\Omega_i$ de variation de ladite position z, avec $F_i$ et $G_i$ des coefficients constants de ladite fonction affine pour chaque intervalle $\Omega_i$.

5. Procédé selon l'une des revendications précédentes, dans lequel on construit ledit modèle de la force $F_{rad}$ de radiation par une équation du type :

22

$F_{rad}(t) = -M_\infty \ddot{z}(t) - F_r(t)$ avec $F_r(t) = \int_0^t h(t-\tau)\dot{z}(\tau)d\tau$ l'amortissement de radiation, $\ddot{z}$ l'accélération dudit moyen mobile (2), $M_\infty$ la masse ajoutée à la fréquence infiniment élevée, $\dot{z}$ la vitesse dudit moyen mobile (2), h la réponse impulsionnelle qui relie la vitesse du moyen mobile à l'amortissement de radiation.

6. Procédé selon la revendication 5, dans lequel on mesure l'accélération dudit moyen mobile (2).

7. Procédé selon la revendication 6, dans lequel on détermine l'amortissement de radiation $F_r$ au moyen d'une réponse temporelle approximée issue d'une réalisation d'état, du type: $F_r(t) = C_r \int_0^t e^{(t-\tau)A_r} B_r \dot{z}(\tau)\, d\tau + D_r \dot{z}(t)$ avec $A_r, B_r, C_r, D_r$ des matrices de la réalisation d'état.

8. Procédé selon les revendications 2 et 7, dans lequel on détermine ladite force d'excitation $F_{ex}$ exercée par la houle incidente sur ledit moyen mobile (2) au moyen d'une équation du type :

$$\hat{F}_{ex}(k) = (M + M_\infty)\ddot{z}(k) + \sum_{l=0}^{k-1} C_{rd} A_{rd}^{k-1-l} B_{rd}\dot{z}(l) + D_{rd}\dot{z}(k) + F_i z(k) + G_i + F_u(k)$$

avec k le pas de temps dans le domaine discret, $A_{rd}, B_{rd}, C_{rd}, D_{rd}$ les matrices de la réalisation d'état dans le domaine discret.

9. Procédé selon la revendication 5, dans lequel on détermine ladite force d'excitation $F_{ex}$ exercée par la houle incidente sur ledit moyen mobile (2) au moyen d'un observateur d'état basé sur un filtre de Kalman linéaire construit à partir d'un modèle de marche aléatoire de ladite force d'excitation $F_{ex}$ exercée par la houle incidente sur ledit moyen mobile (2).

10. Procédé selon la revendication 9, dans lequel on détermine ladite force d'excitation $F_{ex}$ exercée par la houle incidente sur ledit moyen mobile (2) en mettant en œuvre les étapes suivantes :

i) on initialise k=0, le vecteur d'état $\hat{x}_a(0|0) = \bar{x}_a(0)$ et l'état de la matrice de covariance, $P(0|0) = P_0$, ;
ii) à chaque instant k, on acquiert lesdites mesures de position et de vitesse dudit moyen mobile $y(k) = [z(k)\ \dot{z}(k)]$ et la mesure de ladite force exercé par ladite machine de conversion sur ledit moyen mobile $u(k) = F_u(k)$ ; et
iii) à chaque instant k, on détermine la force d'excitation exercée par la houle incidente sur ledit moyen mobile (2) $\hat{w}(k)$ au moyen des équations suivantes :

$$\hat{w}(k) = \begin{bmatrix} 0 & 1 \end{bmatrix} \hat{x}_a(k|k)$$

avec :

$$\begin{cases} \hat{x}_a(k|k-1) = A_a\hat{x}_a(k-1|k-1) + B_a F_u(k-1) \\ P(k|k-1) = A_a P(k-1|k-1)A_a^T + Q \end{cases},$$

$$K(k) = P(k|k-1)C_a^T(C_a P(k|k-1)C_a^T + R)^{-1}$$

$$\hat{x}_a(k|k) = \hat{x}_a(k|k-1) + K(k)(y(k) - C_a\hat{x}_a(k|k-1) - D_a F_u(k))$$

$$P(k|k) = (I - K(k)C_a(k))P(k|k-1)$$

avec K(k) le gain de l'observateur, $x_a(k)$ le vecteur d'état inconnu $x_a(k) = \begin{bmatrix} x(k) \\ w(k) \end{bmatrix}$, $A_a, B_a, C_a, D_a$ des matrices de la réalisation d'état, P la matrice de covariance du vecteur d'état, Q et R des matrices de calibration.

**11.** Procédé selon la revendication 5, dans lequel on détermine ladite force d'excitation F$_{ex}$ exercée par la houle incidente sur ledit moyen mobile (2) au moyen d'un estimateur d'état à entrée inconnue basé sur une approche d'horizon glissant.

**12.** Procédé selon la revendication 11, dans lequel on détermine ladite force d'excitation F$_{ex}$ exercée par la houle incidente sur ledit moyen mobile (2) en mettant en œuvre les étapes suivantes à chaque instant k :

i) on acquiert lesdites mesures de position et de vitesse dudit moyen mobile $y(k) = [z(k)\ \dot{z}(k)]$ et la mesure de ladite force exercée par ladite machine de conversion sur ledit moyen mobile $u(k) = F_u(k)$ ; et

ii) on détermine la force d'excitation exercée par la houle incidente sur ledit moyen mobile $\hat{w}(k|k)$ au moyen des équations suivantes : $\hat{w}(k|k) = \xi(N)$ avec $\xi(N)$ obtenu par résolution d'un problème de programmation quadratique

$$\begin{cases} \min_\xi \left\{ \xi^T(\mathbf{P} + \Psi_s^T \mathbf{R}\Psi_s)\xi - 2[\hat{w}_0^T \quad \hat{x}_0^T \quad V^T]\begin{bmatrix} \mathbf{S} \\ \mathbf{R}\Psi_s \end{bmatrix}\xi \right\} \\ \text{tel que } H_\xi\xi \leq g_\xi + H_d U_d \end{cases}$$

suivant : avec P, R et S des matrices formées à partir de matrices de pondération de la fonction coût, $\xi$ la matrice qui représente l'ensemble des valeurs des variables inconnues sur la fenêtre d'estimation de dimension N, $\Psi_s$ la matrice, calculée à partir de la représentation d'état, qui correspond à l'effet de ces variables sur les valeurs des sorties sur cette même fenêtre, $H_\xi$ et $H_d$ des matrices et $g_\xi$ un vecteur obtenus à partir de contraintes imposées sur l'état et l'entrée inconnue, $\hat{x}_0 = \hat{x}(k - N|k - 1)$ et $\hat{w}_0 = \hat{w}(k - N|k - 1)$ avec x le vecteur d'état et w l'entrée inconnue de l'estimateur d'état,

$$U_d = \begin{bmatrix} u_d(k-N) \\ u_d(k-N+1) \\ \vdots \\ u_d(k) \end{bmatrix},$$

$u_d$ étant l'entrée connue de l'estimateur d'état avec $u_d(t)=F_{hd}(t) - F_u(t)$.

**Patentansprüche**

**1.** Verfahren zur Steuerung eines Wellenenergiesystems (1) mit Hilfe der Bestimmung der Erregerkraft, die von der auf ein mobiles Mittel (2) des Wellenenergiesystems (1) auftreffenden Welle ausgeübt wird, wobei das Wellenenergiesystem (1) die Energie der Welle in Energie mit Hilfe des mobilen Mittels (2) umwandelt, das mit einer Umwandlungsmaschine (3) zusammenwirkt, wobei das mobile Mittel (2) eine Bewegung in Bezug auf die Umwandlungsmaschine (3) unter der Einwirkung der Welle ausführt, **dadurch gekennzeichnet, dass** die folgenden Schritte durchgeführt werden:

a) die Position und die Geschwindigkeit des mobilen Mittels (2) werden gemessen;
b) die Kraft F$_u$ wird gemessen, die von der Umwandlungsmaschine (3) auf das mobile Mittel (2) ausgeübt wird;
c) ein Modell der Strahlungskraft F$_{rad}$ wird konstruiert, die auf das mobile Mittel (2) ausgeübt wird, wobei das Modell der Strahlungskraft F$_{rad}$ die Strahlungskraft mit der Geschwindigkeit des mobilen Mittels (2) verbindet;
d) ein dynamisches Modell des Wellenenergiesystems wird konstruiert, das die Erregerkraft F$_{ex}$, die von der auf das mobile Mittel (2) auftreffenden Welle ausgeübt wird, mit der Position des mobilen Mittels (2), mit der Geschwindigkeit des mobilen Mittels (2), mit der Kraft F$_u$, die von der Umwandlungsmaschine (3) auf das mobile Mittel (2) ausgeübt wird, und mit der Strahlungskraft F$_{rad}$, die auf das mobile Mittel (2) ausgeübt wird, verbindet;
e) die Erregerkraft F$_{ex}$, die von der auf das mobile Mittel (2) auftreffenden Welle ausgeübt wird, wird mit Hilfe des dynamischen Modells, des Modells der Strahlungskraft, der gemessenen Position und Geschwindigkeit und der gemessenen Kraft F$_u$, die von der Umwandlungsmaschine (3) auf das mobile Mittel (2) ausgeübt wird, bestimmt; und
f) das Wellenenergiesystem wird als Funktion der bestimmten Erregerkraft F$_{ex}$, die von der auf das mobile Mittel (2) auftreffenden Welle ausgeübt wird, gesteuert.

**2.** Verfahren nach Anspruch 1, wobei das dynamische Modell des Wellenenergiesystems bestimmt wird mit Hilfe einer Gleichung des Typs:

$$M\ddot{z}(t) = F_{ex}(t) + F_{hd}(t) + F_{rad}(t) - F_u(t)$$

wobei M die Masse des mobilen Mittels ist, $\ddot{z}$ die Beschleunigung des mobilen Mittels (2) ist, $F_{hd}$ die hydrostatische Rückholkraft ist, die auf das mobile Mittel (2) ausgeübt wird.

3.  Verfahren nach Anspruch 2, wobei die hydrostatische Rückholkraft $F_{hd}$ bestimmt wird mit Hilfe einer Formel des Typs: $F_{hd}(t) = -Kz(t)$ wobei z die Position des mobilen Mittels ist, und K der hydrostatische Steifigkeitskoeffizient ist.

4.  Verfahren nach Anspruch 2, wobei die hydrostatische Rückholkraft $F_{hd}$ bestimmt wird durch eine schrittweise affine Funktion des Typs: $F_{hd} = F_i z(t) - G_i$ für mindestens zwei Intervalle $\Omega_i$ der Variation der Position z, wobei $F_i$ und $G_i$ konstante Koeffizienten der affinen Funktion für jedes Intervall $\Omega_i$ sind.

5.  Verfahren nach einem der vorhergehenden Ansprüche, wobei das Modell der Strahlungskraft $F_{rad}$ konstruiert wird durch eine Gleichung des Typs:

$$F_{rad}(t) = -M_\infty \ddot{z}(t) - F_r(t) \text{ wobei } F_r(t) = \int_0^t h(t-\tau)\dot{z}(\tau)d\tau$$

die Strahlungsdämpfung ist, $\ddot{z}$ die Beschleunigung des mobilen Mittels (2) ist, $M_\infty$ die Masse ist, die zur unendlich erhöhten Frequenz hinzugefügt wird, z die Geschwindigkeit des mobilen Mittels (2) ist, h die Impulsantwort ist, welche die Geschwindigkeit des mobilen Mittels mit der Strahlungsdämpfung verbindet.

6.  Verfahren nach Anspruch 5, wobei die Beschleunigung des mobilen Mittels (2) gemessen wird.

7.  Verfahren nach Anspruch 6, wobei die Strahlungsdämpfung $F_r$ bestimmt wird mit Hilfe einer approximierten zeitlichen Antwort aus einer Zustandsraumdarstellung des Typs:

$$F_r(t) = C_r \int_0^t e^{(t-\tau)A_r} B_r \dot{z}(\tau)d\tau + D_r \dot{z}(t)$$

wobei $A_r$, $B_r$, $C_r$, $D_r$ die Matrizen der Zustandsraumdarstellung sind.

8.  Verfahren nach den Ansprüchen 2 und 7, wobei die Erregerkraft $F_{ex}$, die von der auf das mobile Mittel (2) auftreffenden Welle ausgeübt wird, bestimmt wird mit Hilfe einer Gleichung des Typs:

$$\hat{F}_{ex}(k) = (M + M_\infty)\ddot{z}(k) + \sum_{l=0}^{k-1} C_{rd} A_{rd}^{k-1-l} B_{rd} \dot{z}(l) + D_{rd} \dot{z}(k) + F_i z(k) + G_i + F_u(k)$$

wobei k der Zeitschritt in der diskreten Domäne ist, $A_{rd}$, $B_{rd}$, $C_{rd}$, $D_{rd}$ die Matrizen der Zustandsraumdarstellung in der diskreten Domäne sind.

9.  Verfahren nach Anspruch 5, wobei die Erregerkraft $F_{ex}$, die von der auf das mobile Mittel (2) auftreffenden Welle ausgeübt wird, mit Hilfe eines Zustandsbeobachters auf der Basis eines linearen Kalman-Filters bestimmt wird, das aus einem Irrfahrtsmodell der Erregerkraft $F_{ex}$ konstruiert wird, die von der auf das mobile Mittel (2) auftreffenden Welle ausgeübt wird.

10. Verfahren nach Anspruch 9, wobei die Erregerkraft $F_{ex}$, die von der auf das mobile Mittel (2) auftreffenden Welle ausgeübt wird, bestimmt wird, indem die folgenden Schritte durchgeführt werden:

i) k = 0, der Zustandsvektor $\hat{x}_a(0|0) = \bar{x}_a(0)$ und der Zustand der Kovarianzmatrix $P(0|0) = P_0$, werden initialisiert;
ii) zu jedem Moment k werden die Messungen der Position und der Geschwindigkeit des mobilen Mittels y(k) = [z(k) z(k)] und die Messung der Kraft, die von der Umwandlungsmaschine auf das mobile Mittel ausgeübt wird, u(k) = $F_u$(k) erfasst; und
(iii) zu jedem Moment k wird die Erregerkraft, die von der auf das mobile Mittel (2) auftreffenden Welle ausgeübt wird, $\hat{w}$(k) mit Hilfe der folgenden Gleichungen bestimmt:

$$\hat{w}(k) = [0 \; 1]\hat{x}_a(k|k)$$

wobei

$$\begin{cases} \hat{x}_a(k|k-1) = A_a\hat{x}_a(k-1|k-1) + B_aF_u(k-1) \\ P(k|k-1) = A_aP(k-1|k-1)A_a^T + Q \end{cases},$$

$$K(k) = P(k|k-1)C_a^T(C_aP(k|k-1)C_a^T + R)^{-1}$$

$$\hat{x}_a(k|k) = \hat{x}_a(k|k-1) + K(k)\big(y(k) - C_a\hat{x}_a(k|k-1) - D_aF_u(k)\big)$$

$$P(k|k) = \big(I - K(k)C_a(k)\big)P(k|k-1)$$

wobei K(k) die Verstärkung des Beobachters ist, $x_a(k)$ der Vektor des unbekannten Zustands ist

$$x_a(k) = \begin{bmatrix} x(k) \\ w(k) \end{bmatrix}, A_a, B_a, C_a, D_a$$

die Matrizen der Zustandsraumdarstellung sind, P die Matrix der Kovarianz des Zustandsvektors ist, Q und R Kalibrierungsmatrizen sind.

11. Verfahren nach Anspruch 5, wobei die Erregerkraft $F_{ex}$, die von der auf das mobile Mittel (2) auftreffenden Welle ausgeübt wird, mit Hilfe eines Zustandsschätzers mit unbekanntem Eingang auf der Basis eines Ansatzes eines gleitenden Horizonts bestimmt wird.

12. Verfahren nach Anspruch 11, wobei die Erregerkraft $F_{ex}$, die von der auf das mobile Mittel (2) auftreffenden Welle ausgeübt wird, bestimmt wird, indem die folgenden Schritte zu jedem Moment k durchgeführt werden:

i) die Messungen der Position und der Geschwindigkeit des mobilen Mittels y(k) = [z(k) z(k)] und die Messung der Kraft, die von der Umwandlungsmaschine auf das mobile Mittel ausgeübt wird, u(k) = $F_u$(k) werden erfasst; und
(ii) die Erregerkraft, die von der auf das mobile Mittel auftreffenden Welle ausgeübt wird, $\hat{w}(k|k)$ wird bestimmt mit Hilfe der folgenden Gleichungen:

$$\hat{w}(k|k) = \xi(N) \text{ wobei } \xi(N)$$

erhalten wird durch Auflösung eines folgenden Problems der quadratischen Programmierung:

$$\begin{cases} min_\xi\{\xi^T(\boldsymbol{P} + \Psi_s^T\boldsymbol{R}\Psi_s)\xi - 2[\hat{w}_0^T \; \hat{x}_0^T \; V^T]\begin{bmatrix} \boldsymbol{S} \\ \boldsymbol{R}\Psi_s \end{bmatrix}\xi\} \\ \text{sodass } H_\xi\xi \le g_\xi + H_\alpha U_\alpha \end{cases}$$

wobei P, R und S Matrizen sind, die aus Gewichtungsmatrizen der Kostenfunktion gebildet werden, $\xi$ die Matrix ist, welche die Gesamtheit der Werte der unbekannten Variablen im Dimensionsschätzfenster darstellt, N, $\Psi_s$ die aus der Zustandsraumdarstellung berechnete Matrix ist, die der Wirkung dieser Variablen auf die Ausgangswerte in demselben Fenster entspricht, $H_\xi$ und $H_\alpha$ Matrizen sind, und $g_\xi$ ein Vektor ist, die aus Einschränkungen erhalten werden, die an den Zustand und den unbekannten Eingang angelegt werden,

$$\hat{x}_0 = \hat{x}(k - N|k - 1) \text{ und } \hat{w}_0 = \hat{w}(k - N|k - 1)$$

wobei x der Zustandsvektor ist, und w der unbekannte Eingang des Zustandsschätzers ist,

$$U_d = \begin{bmatrix} u_d(k - N) \\ u_d(k - N + 1) \\ \vdots \\ u_d(k) \end{bmatrix}$$

wobei $u_d$ der bekannte Eingang des Zustandsschätzers ist, wobei

$$u_d(t) = F_{hd}(t) - F_u(t).$$

**Claims**

1. Method for controlling a wave-energy system (1) by determining the excitation force applied by the wave incident upon a moving part (2) of the said wave-energy system (1), the said wave-energy system (1) converting the energy of the wave into energy by means of the said moving part (2) cooperating with a conversion machine (3), the said moving part (2) performing a movement in relation to the said conversion machine (3) as a result of the action of the wave, **characterized in that** the following steps are performed:

   a) measurement of the position and speed of the said moving part (2);
   b) measurement of the force $F_u$ applied by the said conversion machine (3) to the said moving part (2) ;
   c) construction of a model of the radiation force $F_{rad}$ applied to the said moving part (2), the said model of the radiation force $F_{rad}$ relating the said radiation force to the speed of the said moving part (2);
   d) construction of a model of the dynamics of the said wave-energy system which relates the said excitation force $F_{ex}$ applied by the wave incident upon the said moving part (2), to the said position of the said moving part (2), to the said speed of the moving part (2), to the said force $F_u$ applied by the said conversion machine (3) to the said moving part (2), and to the said radiation force $F_{rad}$ applied to the said moving part (2);
   e) determination of the said excitation force $F_{ex}$ applied by the wave incident upon the said moving part (2) by means of the said dynamics model, the said model of the radiation force, the said position and speed measured and the said measured force $F_u$ applied by the said conversion machine (3) to the said moving part (2); and
   f) controlling of the said wave-energy system depending on the said determined excitation force Fex applied by the wave incident upon the said moving part (2).

2. Method according to Claim 1, wherein the said dynamics model of the said wave-energy system is constructed by means of an equation of the type: $M\ddot{z}(t) = F_{ex}(t) + F_{hd}(t) + F_{rad}(t) - F_u(t)$ where M is the mass of the moving part, $\ddot{z}$ is the acceleration of the said moving part (2), $F_{hd}$ is the hydrostatic restoring force applied to the said moving part (2).

3. Method according to Claim 2, wherein the said hydrostatic restoring force $F_{hd}$ is determined by means of a formula of the type: $F_{hd}(t) = -Kz(t)$ where z is the position of the said moving part and K is the hydrostatic stiffness coefficient.

4. Method according to Claim 2, wherein the said hydrostatic restoring force $F_{hd}$ is determined by a piecewise affine function of the type: $F_{hd} = -F_i z(t) - G_i$ for at least two variation intervals $\Omega_i$ of the said position z, where Fi and Gi are constant coefficients of the said affine function for each interval $\Omega_i$.

5. Method according to one of the preceding claims, wherein the said model of the radiation force $F_{rad}$ is constructed by an equation of the type:

$F_{rad}(t) = -M_\infty \ddot{z}(t) - F_r(t)$ where $F_r(t) = \int_0^t h(t - \tau)\dot{z}(\tau)d\tau$ is the radiation damping, $\ddot{z}$ is the acceleration of the said moving part (2), $M_\infty$ is the mass added to the infinitely high frequency, $\dot{z}$ is the speed of the said moving part (2), h is the pulse response which relates the speed of the moving part to the radiation damping.

**6.** Method according to Claim 5, wherein the acceleration of the said moving part (2) is measured.

**7.** Method according to Claim 6, wherein the radiation damping $F_r$ is determined by means of an approximated time response obtained from a state realization, of the type : $F_r(t) = C_r \int_0^t e^{(t-\tau)A_r} B_r \dot{z}(\tau)\,d\tau + D_r \dot{z}(t)$ where $A_r, B_r, C_r, D_r$ are state realization matrices.

**8.** Method according to Claims 2 and 7, wherein the said excitation force $F_{ex}$ applied by the wave incident upon the said moving part (2) is determined by means of an equation of the type: $\hat{F}_{ex}(k) = (M + M_\infty)\ddot{z}(k) + \sum_{l=0}^{k-1} C_{rd}\, A_{rd}^{k-1-l} B_{rd}\dot{z}(l) + D_{rd}\dot{z}(k) + F_i z(k) + G_i + F_u(k)$ where k is the time step in the discrete domain, and $A_{rd}, B_{rd}, C_{rd}, D_{rd}$ are the state realization matrices in the discrete domain.

**9.** Method according to Claim 5, wherein the said excitation force $F_{ex}$ applied by the wave incident upon the said moving part (2) is determined by means of a state observer based on a linear Kalman filter constructed from a random-walk model of the said excitation force $F_{ex}$ applied by the wave incident upon the said moving part (2).

**10.** Method according to Claim 9, wherein the said excitation force $F_{ex}$ applied by the wave incident upon the said moving part (2) is determined by performing the following steps:

i) initialization of k=0, the state vector $\hat{x}_a(0|0) = \bar{x}_a(0)$ and the state of the covariance matrix, $P(0|0) = P_0$, ;

ii) at each instant k, acquisition of the said position and speed measurements of the said moving part $y(k) = [z(k)\ \dot{z}(k)]$; and the measurement of the said force exerted by the said conversion machine on the said moving part u(k)= $F_u(k)$ and

iii) at each instant k, determination of the excitation force applied by the wave incident upon the said moving part (2) $\hat{w}(k)$ by means of the following equations :

$$\hat{w}(k) = \begin{bmatrix} 0 & 1 \end{bmatrix} \hat{x}_a(k|k)$$

where :

$$\begin{cases} \hat{x}_a(k|k-1) = A_a \hat{x}_a(k-1|k-1) + B_a F_u(k-1) \\ P(k|k-1) = A_a P(k-1|k-1) A_a^T + Q \end{cases},$$

$$K(k) = P(k|k-1) C_a^T (C_a P(k|k-1) C_a^T + R)^{-1}$$

$$\hat{x}_a(k|k) = \hat{x}_a(k|k-1) + K(k)(y(k) - C_a \hat{x}_a(k|k-1) - D_a F_u(k))$$

$$P(k|k) = (I - K(k) C_a(k)) P(k|k-1)$$

where K(k) is the gain of the observer, $x_a(k)$ is the unknown state vector $x_a(k) = \begin{bmatrix} x(k) \\ w(k) \end{bmatrix}$, $A_a, B_a, C_a, D_a$ are state realization matrices, P is the covariance matrix of the state vector, and Q and R are calibration matrices.

**11.** Method according to Claim 5, wherein the said excitation force $F_{ex}$ applied by the wave incident upon the said moving part (2) is determined by means of an unknown input state estimator based on a moving-horizon approach.

**12.** Method according to Claim 11, wherein the said excitation force $F_{ex}$ applied by the wave incident upon the said moving part (2) is determined by performing the following steps at each instant k :

i) acquisition of the said position and speed measurements of the said moving part $y(k) = [z(k)\ \dot{z}(k)]$ and the measurement of the said force applied by the said conversion machine to the said moving part $u(k) = F_u(k)$ ; and

ii) determination of the excitation force applied by the wave incident upon the said moving part $\hat{w}(k|k)$ by means of the following equations:

$\hat{w}(k|k) = \xi(N)$ where $\xi(N)$ is obtained by resolution of a following quadratic programming problem:

$$\begin{cases} \min_{\xi}\left\{ \xi^T(\mathbf{P} + \Psi_s^T \mathbf{R}\Psi_s)\xi - 2[\hat{w}_0^T \quad \hat{x}_0^T \quad V^T]\begin{bmatrix} \mathbf{S} \\ \mathbf{R}\Psi_s \end{bmatrix}\xi \right\} \\ \text{such as } H_\xi \xi \leq g_\xi + H_d U_d \end{cases}$$

where P, R and S are matrices formed from matrices for weighting of the cost function, $\xi$ is the matrix which represents all the values of the unknown variables in the estimation window of size $N$, $\Psi_s$ is the matrix, calculated from the state representation, which corresponds to the effect of these variables on the output values in the same window, $H_\xi$ and $H_d$ are matrices and $g_\xi$ is a vector obtained from constraints imposed on the state and the unknown input,

$\hat{x}_0 = \hat{x}(k - N|k - 1)$ and $\hat{w}_0 = \hat{w}(k - N|k - 1)$ where x is the state vector and w the unknown input of the state estimator,

$$U_d = \begin{bmatrix} u_d(k - N) \\ u_d(k - N + 1) \\ \vdots \\ u_d(k) \end{bmatrix},$$

$u_d$ being the known input of the state estimator with $u_d(t)=F_{hd}(t) - F_u(t)$.

**Figure 1**

**Figure 2**

**Figure 3**

**Figure 4a**

EP 3 440 342 B1

**Figure 4b**

**Figure 4c**

32

Figure 5a

Figure 5b

**Figure 5c**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2876751
- WO 2009081042 A
- FR 2973448
- US 9261070 B

**Littérature non-brevet citée dans la description**

- **PETER KRACHT ; SEBASTIAN PEREZ-BECKER ; JEAN-BAPTISTE RICHARD ; BORIS FISCHER.** Performance Improvement of a Point Absorber Wave Energy Converter by Application of an Observer-Based Control: Results from Wave Tank Testing. *IEEE Transactions on Industry Applications,* Juillet 2015
- **BRADLEY A LING.** Real-Time Estimation and Prediction of Wave Excitation Forces for Wave Energy Control Applications. *ASME 2015 34th,* 2015
- **NIELSEN SÖREN R K et al.** Optimal control of non linear wave energy point converter. *OCEAN ENGINEERING,* 24 Juillet 2013, vol. 72, 176-187
- **FAINES J ; KURNIAWAN A.** Fundamental formulae for wave-energy conversion. *R. Soc. open sci.,* 2005, vol. 2, 140305, http://dx.doi.org/10.1098/rsos.140305